(19) Europäisches Patentamt
European Patent Office
Office européen des brevets

(11) EP 2 267 199 A2

(12) EUROPEAN PATENT APPLICATION

(43) Date of publication:
**29.12.2010 Bulletin 2010/52**

(21) Application number: **10185802.5**

(22) Date of filing: **28.09.2007**

(51) Int Cl.:
***D01F 9/08*** *(2006.01)* ***D01D 5/00*** *(2006.01)*
***H01M 10/05*** *(2010.01)* ***C30B 29/16*** *(2006.01)*
***C30B 29/60*** *(2006.01)*

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **29.09.2006 US 848189 P**
**22.03.2007 US 919453 P**
**22.05.2007 US 939498 P**

(62) Document number(s) of the earlier application(s) in accordance with Art. 76 EPC:
**07873978.6 / 2 086 877**

(71) Applicant: **The University of Akron**
**Akron, Ohio 44325 (US)**

(72) Inventors:
- **Chase, George C.**
**Wadsworth, OH 44281 (US)**
- **Espe, Matthew P.**
**Akron, OH 44302 (US)**
- **Evans, Edward A.**
**Hudson, OH 44326 (US)**
- **Ramsier, Rex D.**
**Alliance, OH 44601 (US)**
- **Reneker, Darrell H.**
**Stow, OH 44224 (US)**
- **Tuttle, Richard W.**
**Irwin, OH 15642 (US)**
- **Rapp, Jennifer**
**Ames, IA 50010 (US)**

(74) Representative: **von Kreisler Selting Werner**
**Deichmannhaus am Dom**
**Bahnhofsvorplatz 1**
**50667 Köln (DE)**

Remarks:
This application was filed on 01-10-2010 as a divisional application to the application mentioned under INID code 62.

(54) **Metal oxide fibers and nanofibers, method for making same, and uses thereof**

(57) The present invention generally relates to metal oxide fibers and nanofibers, the processes for making same, and uses thereof. Such metal oxide nanofibers possess the ability to absorb and decompose chemical warfare agents and other toxic chemicals. These nanofibers can be incorporated into protective clothing and devices for breathing or in another example may be used in lithium-ion batteries. In one embodiment, the present invention relates to titania, alumina, and/or magnesia fibers and nanofibers, and to processes for making same. In another instance, alpha-phase aluminum oxide is utilized as one material in nanofibers.

EP 2 267 199 A2

## Description

RELATED APPLICATION DATA

This application is related to currently pending U.S. Provisional Application No. 60/848,189, entitled "Metal Oxide Fibers and Nanofibers, Method for Making Same and Uses Thereof" filed on September 29, 2006, U.S. Provisional Application No. 60/919,453, entitled "Metal Oxide Fibers and Nanofibers, Method for Making Same and Uses Thereof" filed on March 22, 2007, and U.S. Provisional Application No. 60/939,498 entitled "Fabrication of Alumina Nanofibers Containing Lithium Salts for Use as Separator/Electrolyte Materials in Lithium-Ion Batteries" filed on May 22, 2007, each of which is incorporated herein by reference in their entireties.

FIELD OF THE INVENTION

The present invention generally relates to metal oxide fibers and nanofibers, the processes for making same, and uses thereof. Such metal oxide nanofibers possess the ability to absorb and decompose chemical warfare agents and other toxic chemicals. These nanofibers can be incorporated into protective clothing and devices for breathing or in another example may be used in lithium-ion batteries. In one embodiment, the present invention relates to titania, alumina, and/or magnesia fibers and nanofibers, and to processes for making same. In another instance, alpha-phase aluminum oxide is utilized as one material in nanofibers.

BACKGROUND OF INVENTION

Many of the chemical warfare nerve agents developed since World War I are organophosphorus esters. These species are liquids under normal environmental conditions and are intended to be dispersed as aerosols in the battlefield. Human exposure to these compounds initiates reactions involving acetylcholinesterase, irreversibly inhibiting control over the central nervous system. The g-agents GB (sarin), GD (soman) and GF have the structure $(RO)PO(CH_3)(F)$, where R varies from straight chain, to branched, to cyclic alkyl groups, respectively. The much more toxic and chemically heterogeneous V- series agents (e.g. VX) contain a P-S linkage to isopropyl amino functional moieties. It is the defunctionalization of these nerve agents by halogen, ester or sulphur bond scission that renders them either much less toxic or non-toxic.

Alumina, titania, magnesia and other oxides can adsorb and in some cases decompose nerve agents and related compounds. The highest surface reactivity has been shown to occur on nano-scale crystalline particles having many edge and defect sites. Such materials, whose properties are dominated by large surface to volume ratios, exhibit reactive behavior used for the decomposition of nerve agents.

It is difficult to incorporate nanoparticles into structures such as clothing or filters intended for field service, since methods to encapsulate or constrain them must not lead to decreased surface area or reactive behavior. It is critical to use materials that exhibit nanoscale surface structure for phosph(on)ate decomposition. These materials are in the form of nanofibers with macroscopic lengths for incorporation into clothing and filters.

Metal oxide nanoparticles are known to decompose nerve agents, but they cannot be incorporated into clothing and breathing filters. Nanofibers can be incorporated into clothing and used in respiratory filters while still exhibiting the nanoscale surface reactivity necessary for nerve agent detoxification. The large surface area of these nanofibers creates a high surface reactivity while the length of nanofibers make them suitable for incorporation into protective clothing and devices for breathing. Properties of the nanofiber materials such as strength, porosity, capacity to absorb chemical species, etc., can be controlled by combining different fibers into a composite. The composites are ideal for protective breathing apparatus and clothing to permit moisture exchange and alleviate thermal stress on the wearer.

Secondary cell batteries (nickel-cadmium, nickel/metal-hydride and lithium-ion rechargeable batteries account for nearly 10% of the global battery market. Rechargeable lithium ion batteries make up a significant amount of that market with growth increasing on an annual basis. This growth in rechargeable and secondary cell batteries is driven by increasing sales in portable devices such as cell phones and laptop computers.

There is therefore a need in the art for a suitable material which can be incorporated as a nanofiber and used in clothing and/or breathing filters for the protection against chemical agents. There is also a need in the art for a suitable material for use in batteries. The use of metal oxide nanofibers offers a means of providing such a suitable material.

SUMMARY OF INVENTION

The present invention generally relates to metal oxide fibers and nanofibers, the processes for making same, and uses thereof. Such metal oxide nanofibers possess the ability to absorb and decompose chemical warfare agents and other toxic chemicals. These nanofibers can be incorporated into protective clothing and devices for breathing or

in another example may be used in lithium-ion batteries. In one embodiment, the present invention relates to titania, alumina, and/or magnesia fibers and nanofibers, and to processes for making same. In another instance, alpha-phase aluminum oxide is utilized as one material in nanofibers.

In one embodiment the present invention relates to a method of producing a metal oxide nanofiber having improved catalytic, conductive, surface or structural functionality comprising the steps of: (I) selecting and providing a least one metal oxide precursor and at least one polymer to at least one nanofiber producing device, (II) mixing the at least one metal oxide precursor, the at least one polymer and optionally a solvent, (III) electrospinning the resultant mixture to produce fibers containing the at least one metal oxide precursor and the at least one polymer, (IV) thermally treating the fibers to create the metal oxide nanofiber having improved functionalities, and (V) collecting the metal oxide nanofiber.

In another embodiment the present invention relates to a method of producing a metal oxide nanofiber having improved catalytic, conductive, surface or structural functionality comprising the steps of: (a) selecting and providing one or more polymer nanofibers, (b) coating the one or more polymer nanofibers with sol-gel precursors, (c) thermally treating the one or more polymer nanofibers and sol-gel mix to transform the resultant sheet into metal oxides, (d) incorporating the polymer nanofibers into compatible micro-sized fiber filter media via vacuum molding, and (e) optionally using an acrylic binder to hold the metal oxide nanofibers together.

In yet another embodiment the present invention relates to a method of producing a metal oxide nanofiber having improved catalytic, conductive, surface or structural functionality comprising the steps of: (i) selecting and providing one or more polymer nanofibers, (ii) coating the one or more polymer nanofibers with sol-gel precursors, (iii) incorporating the polymer nanofibers into compatible micro-sized fiber filter media via vacuum molding, (iv) thermally treating the one or more polymer nanofibers and sol-gel mix to transform the resultant sheet into metal oxides, and (v) optionally using an acrylic binder to hold the metal oxide nanofibers together.

In still yet another embodiment the present invention relates to a method of producing a composite metal oxide nanofiber and polymer nanofiber having improved catalytic, conductive, surface or structural functionality comprising the steps of: (A) selecting and providing a least one metal oxide precursor and/or metal oxide nanoparticles to at least one nanofiber producing device, (B) selecting and providing a least one polymer to the at least one nanofiber producing device, (C) mixing the at least one metal oxide precursor and/or metal oxide nanoparticles, the at least one polymer and optionally a solvent, (D) electrospinning the resultant mixture to produce fibers containing the at least one metal oxide precursor and/or metal oxide nanoparticles and the at least one polymer, (E) thermally treating the fibers to create the composite metal oxide nanofiber and polymer nanofiber having improved functionalities, and (F) collecting the composite metal oxide nanofiber and polymer nanofiber.

In another embodiment the present invention relates to an electrospun, metal oxide nanofiber having improved catalytic, conductive, surface or structural functionality comprising: one or more metal oxides precursors, one or more polymers, and the one or more metal oxide precursors and one or more polymers selected so as to be compatible with one another.

In still yet another embodiment the present invention relates to a device for protecting against chemical exposure comprising one or more metal oxide nanofibers.

In another embodiment the present invention relates to an electrolyte for use in lithium ion batteries comprising an alumina-lithium salt nanofiber made from lithium salt incorporated into or onto alumina nanofibers.

## BRIEF DESCRIPTION OF THE DRAWINGS

Figure 1 details a view of Titanium-Ultraviolet Light -Anatase Experimental Setup;

Figure 2 is a graph of UV Light intensity vs. current for 400V and 5 sec exposure time;

Figure 3 is a graph of UV Light intensity vs. current for 400V and 10 sec exposure time;

Figure 4 is a graph of UV Light intensity vs. current for 400V and 15 sec exposure time;

Figure 5 is a graph of UV Light intensity vs. current for 700V and 5 sec exposure time;

Figure 6 is a graph of UV Light intensity vs. current for 1000V and 5 sec exposure time;

Figure 7 is a graph of resistivity vs. intensity for sample 1 at 400V - (trend details resistivity increasing with exposure time);

Figure 8 is a graph of resistivity vs. intensity for sample 1 at 700V - (trend details resistivity increasing with exposure time);

Figure 9 is a graph of resistivity vs. intensity for sample 1 at 1000V - (trend details resistivity decreasing with exposure time);

Figure 10 is a photograph illustration of one technique for visualizing electrospinning dynamics;

Figure 11 is a high speed photograph showing color variations within the polymer jet, which can be used to determine

its thickness;
Figure 12 is a photo detailing microscopic evidence of the influence of nanofibers on droplet capture by filtration media;
Figure 13 are photographs of a continuous sheet of polymer nanofibers collected with a rotating solid drum apparatus;
Figure 14 details SEM images of partially aligned Nylon-6 nanofibers after 5 minutes of electrospinning onto the segmented drum apparatus;
Figure 15 are (left) SEM image of polyamide nanofibers mixed with 5 micron glass fibers and (right) Disk filter made of glass fibers and polymer nanofibers. The filter is formed by vacuum molding an aqueous slurry of the fibers with an acrylic binder;
Figure 16 is an SEM image of self-supporting and continuous titania nanofibers after pyrolysis;
Figure 17 is a graph of X-ray diffraction patterns from titania nanofibers after 773 K (lower pattern) and 1173 K (upper pattern) pyrolysis;
Figure 18 shows SEM images of titania nanofibers doped with erbia particles;
Figure 19 is a graph of XPS survey scans of pyrolyzed titania nanofibers and of those incorporating erbia particles;
Figure 20 is a graph of the effect of solution concentration and gap distance on the diameter of electrospun nanofibers;
Figure 21 are photos detailing nanofibers coated with different aluminum nitride films, pyrolysis of the polymer shows that the coatings completely covered the nanofibers;
Figure 22 is an SEM image of as-spun aluminum acetate/PVP nanofibers;
Figure 23 details 51 MHz $^{13}C$ CP/MAS NMR spectra of aluminum acetate (A), polyvinylpyrrolidone (PVP) (B), electrospun fibers (C), aluminum oxide nanofibers heated to 1200˚C (D) with all samples being spun at 5 kHz;
Figure 24 is a graph of thermogravimetric analysis (TGA) data for as-spun PVP/aluminum acetate nanofibers;
Figure 25 details 195 MHz $^{27}Al$ MAS NMR spectra of aluminum acetate (A), electrospun fibers (B), aluminum oxide nanofibers heated to 1200˚C (C), $\alpha$-alumina powder (D) with all samples being spun at 13 kHz;
Figure 26 details XRD from $\alpha$-alumina nanofibers after 1200˚C annealing;
Alpha-phase alumina ($\alpha$) diffraction peaks dominate, however a small percent of borates (B) are detected; the feature labeled with an asterisk is an instrumental artifact;
Figure 27 is a SIMS surface sensitive technique graph detailing the nanofibers containing Na and the effect of impurities;
Figure 28 is a graph of XPS spectra from as-spun nanofibers and $\alpha$-alumina nanofibers after annealing at 1200˚C; note that the sodium and boron levels at the surface after annealing are much higher than expected from the composition of the starting mixture; demonstrating that surface segregation occurs during the crystallization process;
Figure 29 details DRIFTS spectra of as-synthesized nanofibers, nanofibers heated to 1200˚C and $Al_2O_3$ powder (commercial) indicating that borate and hydroxyl modes are present in the heated nanofibers, but not in the powder; the hydroxyl regions of the spectra indicate that the nanofibers may present different acid and base sites at their surfaces than those found on powders, and may therefore lead to enhanced or unique surface chemistry;
Figure 30 is an SEM image of electrospun PVP/Al(ac) fibers;
Figure 31 are SEM images of PVP/AlAc electrospun fibers annealed at various temperatures;
Figure 32 is a graph of X-ray photoelectron spectrum of alumina fiber annealed at 1200˚C;
Figure 33 is a graph of $^{27}Al$ direct polarization NMR spectra of alumina fibers annealed at various temperatures under wet-bake conditions;
Figure 34 is a graph of $^{27}Al$ direct polarization NMR spectra of alumina fibers annealed at various temperatures under dry-bake conditions;
Figure 35 is a graph of powder X-ray diffraction data from alumina fibers after annealing at various temperatures under dry-bake conditions;
Figure 36 is a graph of $^{1}H \rightarrow ^{27}Al$ cross-polarization NMR spectra from alumina fibers annealed under dry-bake conditions;
Figure 37 is a graph of DRIFTS spectra from alumina fibers annealed under wetbake conditions;
Figure 38 is a schematic representation of configurations for heating alumina fiber mats;
Figure 39 is a graph of $^{27}Al$ SSNMR spectra from aluminum acetate (bottom) and aluminum acetate annealed for 30 minutes at 525˚C (top);
Figure 40 is a drawing of the design of a Li ion battery, where the separator/electrolyte is fabricated from alumina/LiX nanofibers; and
Figure 41 is an SEM micrograph from electrospun nanofibers of PVP/aluminum acetate/LiI, after annealing at 400˚C.

## DETAILED DESCRIPTION OF THE INVENTION

The present invention generally relates to metal oxide fibers and nanofibers, the processes for making same, and uses thereof. Such metal oxide nanofibers possess the ability to absorb and decompose chemical warfare agents and other toxic chemicals. These nanofibers can be incorporated into protective clothing and devices for breathing or

in another example may be used in lithium-ion batteries. In one embodiment, the present invention relates to titania, alumina, and/or magnesia fibers and nanofibers, and to processes for making same. In another instance, alpha-phase aluminum oxide is utilized as one material in nanofibers.

For purposes of this invention thermal treatment involves exposing the as-spun nanofibers to elevated temperatures under a specified atmosphere. In the simplest application of the thermal treatment the nanofibers are heated to remove residual solvent and/or water. In the more general situation, the sample is heated to pyrolize the organic material (polymer and any organic portions of the metal oxide precursor), calcine the metal-oxide and sinter particles to generate a metal-oxide, or doped metal-oxide based nanofiber. The temperature may range form ambient/21˚C to 1200˚C. The sample heating time can vary between minutes and hours and the sample heating temperature may be static, vary in a linear fashion or vary under a complex heating profile. Slow heating (ramping temperature from 21˚C to 700˚C over several hours) allows the polymer to leave the fiber structure and the metal oxide to take its place to form metal oxide fibers while retaining most of the fiber structure. Further heating to higher temperatures is useful to cause the metal oxides to change crystalline states (phases). Thermal treatment of the nanofibers may result in partial or complete pyrolyses of the organic material present in the nanofiber, partial or complete calcination of metal oxides and sintering of particles. The atmosphere under which the thermal treatment occurs may be ambient atmosphere, an atmosphere enriched or depleted in various gases (oxygen, nitrogen, carbon dioxide, etc.) and/or have a relative humidity between 0 and 100%.

Functionalization, in reference to metal oxide nanofibers, refers to changing the material properties either by changing the composition, changing the structure, or by changing the morphology of the fibers or the fiber structures. Functionalization can be achieved with the "thermal treatment" procedure defined previous. This process controls the oxidation state and coordination number of the metal atom sites in the nanofibers and the number of surface hydroxyl groups present. Certain metal oxidation states and coordination numbers are more reactive, and enhancing the number of these sites increases the reactivity of the nanofibers. Surface hydroxyl groups are also important in a number of reactions, including the de-toxification of nerve agents, and increasing their number increases the efficacy of the nanofibers in nerve agent decomposition. Functionalization is also accomplished by adding catalysts for chemical reactions. The catalyst properties may be developed into the fibers by adding nano or micro metallic particles such as Pd or Pt, by applying a surface coating on the fibers, or by changing the crystal structure of the metal oxide fibers. Functionality may be developed by contacting nanofibers of different metal oxide materials that create photon sensitivity in the fibers and/or fiber structure. For example PN junctions may be formed by contacting NiO and SnO fibers. Functionality may also be developed into the fibers by doping the fibers with other compounds to alter their electrical or thermal conductivity. Alternatively functionality may be developed into the fiber structures in the manner the fiber mats are constructed. For example, fibers oriented parallel to each other will polarize light. Finally, functionality may be incorporated into the fiber structure by coating the surfaces of the fibers to alter their properties. For example, silanes can be coated onto the surfaces of metal oxide fibers to change their wetting properties.

Titanium Nanofibers Exposure to Ultraviolet-light

Titania nanofibers have been discovered to be active in ultraviolet light. Upon the incidence of UV radiation, titania nanofibers make the transition from what is essentially a resistor to a wide band gap semiconductor. The electrical resistivity/conductivity of titania nanofiber varies when exposed to varying intensities of UV light. The variation of titania resistivity with respect to UV intensity, exposure time, and voltage are studied in detail in an experiment conducted varying these parameters. The hypothesis being that as light intensity and exposure time increase, resistivity will decrease. To complete this experiment, 3 anatase samples were tested at three voltages and three exposure times and data was taken three times at each point.

Results of Titanium Nanofiber/Ultraviolet-light Experiments

Resistivity decreased with light intensity for all voltages (400, 700, 1000). At a fixed voltage and exposure time, current increased with increased UV intensity. For the 400V (volt) samples, resistivity increased with longer exposure times, yet for the 700 and 1000V samples, resistivity decreased with exposure time. For UV intensities on the order of 1000 $\mu W/cm^2$, one can expect to see resistivities between 5000 and 20000 Ohm/cm.

Anatase at 400V reaches a minimum resistivity between 5 and 10 seconds of UV exposure. At 700V, the minimum resistivity lies on the threshold of 15 seconds of exposure, while samples at 1000V have a minimum resistivity at an exposure time greater than 15 seconds. Resistivity decreases with increasing intensities of ultraviolet light and at a fixed voltage and exposure time, current increases with increasing ultraviolet intensities.

Prior work related to titania nanofibers has shown that titania is photocatalytic and responds to UV light by making the transition from a resistive material to a semiconductive material. Specific work related to the variation of voltage, exposure time, and light intensity has yet to be completed in this field. A grasp of the magnitude of resistivity

change with respect to these values adds to the pool of knowledge for the successful implementation of titania into far reaching industrial, medical, and chemical possibilities. This discussion approaches these issues through an experimental-empirical graphical technique to demonstrate how changes in these values affect titania response to UV radiation.

Photocatalysis is defined as a catalytic reaction involving light absorption by a catalyst or by a substrate. Titania nanofibers exhibit this behavior by making the transition from a resistive material to a semiconductive material upon the incidence of UV radiation. This phenomenon has importance in several diverse areas.

Perhaps the most important area of application for titania nanofibers is that of the waste water industry. Titania nanofibers can be used to treat waste water because when a photon with the energy hv strikes the titania semiconducting material, an electron is promoted from the valence band of the material to the conductance band of the material, thus creating an electron hole in the valence band. This electron hole ($h_{vb}$) is a strong oxidant which then breaks down organic contaminants and microorganisms that are harmful to the human body. These materials are broken down mainly due to the formation of a hydroxyl radical, which is formed in the following sequence of chemical formulas:

$$(1) TiO_2 + h\upsilon \longrightarrow e_{cb} + h_{vb}$$

$$(2) h_{vb} + Ti--OH \longrightarrow Ti + OH_{radical}$$

Another area of application involves the degradation of PVA (Poly Vinyl Alcohol), a widely used polymeric material. PVA is used in several capacities, however its degradation is very slow and thus a faster more efficient method of PVA breakdown is ideal. Recent research has shown that platinum metal on a titania support can quickly degrade PVA solid waste. A more complete understanding of titania response to UV radiation accelerates the integration of such methods into solid waste materials handling.

Another application of titania nanofibers involves the sterilization of the surface of dental implants. Titania is used here as rough dental implants provide a better surface for installation into the oral cavity, yet a rougher surface is accompanied by a higher affinity for bacterial infection when exposed to the inside of the mouth. Using titania greatly decreases, if not completely abolishes, the risk of oral infection in dental implantations.

Along with varied applications for $TiO_2$, there are also several methods for the fabrication of titania nanofibers. These include electrospinning, vacuum arc plasma evaporation, and sol - gel. Electrospinning techniques involve the dispersion of $TiO_2$ microparticles in a polymer aqueous solution and then spinning the fibers in a high voltage environment onto a rotating wheel type apparatus. An automatically advancing syringe is also utilized in this technique for nanofiber fabrication. Vacuum arc plasma evaporation uses a vacuum chamber supplied with oxygen and a plasma beam focused from a $LaB_6$ cathode onto an anode magnet. The titania deposits onto a glass substrate holder at the end of the chamber opposite the sample source. The sol-gel method involves the preparation of a gel in a specific molar ratio followed by the extrusion of the fibers with a glass stick by hand. Although cumbersome and slow, this method allows for very few impurities.

Experimental Methods of Titanium Nanofiber/Ultraviolet-light

There are a variety of types of titania nanofibers, and based on its superior qualities anatase was chosen as the experimental sample. The anatase samples used were fabricated through an electrospinning technique. Suitable electrospinning techniques are disclosed in various patents, including, but not limited to, United States Patent Number 6,753,454, which is hereby incorporated by reference in its entirety for its teachings related to electrospinning.

This experiment utilized three critical pieces of equipment; a UV light meter, a Keithley voltage source/ current measuring device, and a UV light source. The light source used is a BLAK RAY Longwave UV lamp B 100 AP, 115V 60Hz and 2.5 Amp manufactured May, 1991. The light used is an important factor in this experiment as it impacted the path of the experiment. The UV lightmeter measures light intensity in units of $\mu W/cm^2$, with two available ranges of 0-2000 and 0-20000. The current measuring device measures current in $\mu$Amps, the appropriate range for this experiment.

The original intent of experimental design involved calibrating ultraviolet light intensity to distance, and then varying the titania sample distance from the light source to effectively vary the light intensity. After several experimental trials, this calibration was discovered to be not valid. The intensity of the light varied with time, and a calibration did not accurately represent data. Hence, a reevaluation of experimental procedure was needed.

A 'table - like' framework was created to support the experiment. On this support, a 37cm metal track equipped with a bearing-loaded car moved freely along the distance of the track. The anatase sample was placed on a glass slide

which was then screwed onto a Teflon base via gold plated metal contacts. This sample setup was placed on a fiberglass base along with the UV lightmeter onto the bearing - loaded car. The setup as shown in Figure 1 utilizes the known fact that the UV-A radiation varies with the cosine of the angle between the lines to the meter and sample and the centerline of the UV source. The sample and the meter were placed at equal perpendicular distances from the centerline of the UV light source so as to simultaneously measure the light intensity and disperse incident radiation onto the sample.

Three samples were tested at three voltage settings (400V, 700V, and 1000V) and three exposure times (5, 10, and 15 seconds). Each sample point was taken in triplicate. Exposure times were created by placing an opaque UV blocker directly in front of the light source and then exposing the source to the UV source for the predetermined period of time. Light intensity was varied by taking data at 12 equally spaced intervals along the 37 cm track. This technique allowed for the measurement of the effects of exposure time, voltage, and light intensity on the titania sample.

Data and Results of Titanium Nanofiber/Ultraviolet-light Experiments

Size, weight, and thickness for the three samples used for this experiment are listed below in Table 1. Thickness is determined from the density of anatase (4.26 g/cc).

TABLE 1

| Anatase Sample information | | | | | | |
|---|---|---|---|---|---|---|
| | Length, cm | | Width, cm | | | |
| Sample | Exposed | Weighed | Exposed | Weighed | Weight,g | Thickness, cm |
| 1 | 1.7 | 2.1 | 2 | 2.2 | 0.0050 | 0.000254 |
| 2 | 1.7 | 2.25 | 2.25 | 2.25 | 0.0082 | 0.000380 |
| 3 | 1 | 1.55 | 2.25 | 2.25 | 0.0056 | 0.000377 |

As alluded in the experimental method, a lot of 'raw' data exists for this experiment and therefore graphical output represents the best format for this data.

Figures 2 through 6 graphically represent the averages of light intensity and current flow for the voltages and exposure times indicated by each chart title. Error bars represent the standard deviation of the triplicate data points.

To determine resistance and then resistivity, the following relationships are used:

$$\rho = R * \frac{A}{L} \qquad (3)$$

$$e = iR \qquad (4)$$

where *R* is the resistance in Ohms, ρ is the resistivity in Ohm/cm, *i* is the current in Amps, e is voltage, *A* is the cross-sectional area of the sample and *L* is the length of the sample.

In this manner, the range of resistivities of anatase at the experimental conditions are calculated and represented in Table 2. These ranges are for light intensities between 900 and 1450 $\mu W/cm^2$.

Discussion/ Analysis of Titanium Nanofiber/Ultraviolet-light Experiments

In this data several points are determined. In Table 2, one can see the ranges of resistivity vary greatly from sample to sample, from 5000 Ohm/cm for samples 1 and 2 and up to 25000 Ohm/cm for sample 3. The difference between samples 1 and 2 and samples 3 is a 1.7 cm distance between electrodes for 1 and 2 and a 1 cm difference between electrodes for sample 3.

In each trial the resistivity decreases with increasing UV intensity. One sees, as expected, this behavior by examining Figures 7-9 and the representation by the downward slope to the right of the chart. The explanation supporting this phenomenon states that as more UV light strikes the anatase sample, more electrons are freed from the valence

band to the conductance band. Use of this information allows waste water treatment facilities to treat more biological contaminants as additional electron holes are available to oxidize these contaminants.

TABLE 2

| Resistivity Ranges for Anatase Samples | | | | | | | | | | |
|---|---|---|---|---|---|---|---|---|---|---|
| | | 400V | | | 700V | | | 1000V | | |
| Sample | max/min | 5s | 10s | 15s | 5s | 10s | 15s | 5s | 10s | 15s |
| 1 | minimum | 6130.909 | 7005.043 | 6754.391 | 5396.834 | 5320.432 | 5539.734 | 6042.085 | 5359.507 | 5293.067 |
| | maximum | 5087.35 | 5425.994 | 5228.253 | 3420.446 | 3995.238 | 4873.073 | 4335.81 | 4367.489 | 4480.987 |
| 2 | maximum | 10064.75 | 11524.52 | 12958.9 | 1342.819 | 11625.94 | 10850.09 | 11748.73 | 9702.518 | 8429.435 |
| | minimum | 8182.72 | 9615.999 | 1082.95 | 10728.92 | 8570.951 | 8360.746 | 8839.062 | 7552.335 | 7054.728 |
| 3 | maximum | 19459.26 | 19609.23 | 20601.6 | 23715.16 | 18886.62 | 14854.12 | 24968.58 | 18147.63 | 18357.13 |
| | minimum | 10701.57 | 14944.48 | 15055.02 | 16738.8 | 13086.03 | 11929.06 | 14229.85 | 11639.06 | 11839.45 |

The next observable relationship correlates resistivity and exposure time. For the 400V samples, each sample displays activity opposite than originally expected. One theory being that as exposure time increased, the current would increase and therefore resistivity would decrease. The opposite occurred for the 400V samples as this trend is shown in Figure 7 For the 700V sample 1 this "converse behavior" is also seen. However in samples 2 and 3 the resistivity decreases with longer exposure times, with the trend being very strong for the 1000V samples. This leads the experimenter to believe that a maximum current flow (or minimum resistivity) is achieved for the 400V samples between 5 and 10 seconds of UV exposure time. The threshold of this maximum may be in the 10 to 15 second or somewhat longer range for the 700V samples, and even longer for the 1000V.

One is also able to conclude that for ultraviolet intensities between 900 and 1450 $\mu W/cm^2$, resistivities on the order of 5000-20000 Ohm/cm are expected.

The data collected in this experimental study determines general relationships between the main factors for anatase photoconductivity and provides an experimenter with the working ranges of the variables represented here. Additional work is needed to provide accurate enough results in determining a theoretical model or a mathematically defined 'trend' for future applications. This can be explained by the fact that the method for measuring intensity needs improvement. As described previously, the 'cosine of the angle' approach is satisfactory for an initial study, but a more accurate method of measurement is necessary to be able to accurately predict the behavior of anatase under ultraviolet radiation.

## Protection Against Phosphorus and Sulfur-Based Nerve Agents

Metal oxide nanofibers act as substrates upon which chemical warfare agents and other toxic chemicals can adsorb or absorb and decompose. The large surface area per unit mass of these nanofibers creates a high surface reactivity while the length of the nanofibers make them suitable for incorporation into protective clothing and devices for breathing. Metal oxide nanoparticles are known to decompose nerve agents but cannot be readily incorporated into clothing and breathing filters. Nanofibers can be incorporated into clothing and used in respiratory filters while still exhibiting the nano-scale surface reactivity necessary for nerve agent detoxification. Properties of the nanofiber materials such as strength, porosity, capacity to adsorb chemical species, etc. can be controlled by combining different fibers into a composite. For example, pressure drop across nerve agent filter media can be minimized by combining oxide nanofibers with larger fibers. The composites are ideal for protective breathing apparatus and clothing to permit moisture exchange and alleviate thermal stress on personnel.

Three methods are key in the production and use of metal oxide nanofibers:

(1) direct electrospinning of a solution containing a polymer and a metal oxide precursor, (2) coating of polymer nanofibers, and (3) incorporating metal oxide particles and nanofibers into absorbent polymer nanofibers. The first two methods involve a pyrolysis step to form metal oxide nanofibers, whereas the third method retains polymeric species in the final product. The materials systems include titania, alumina and magnesia - systems known to exhibit high catalytic surface behavior for nerve agent decomposition when in nanoparticle form. Electrospinning is a straightforward and scalable method for producing non-woven mats and sheets of nanofibers. The mixture of polymers, solvents, metal oxide precursors, and the electrospinning conditions control the resulting nanofiber properties. These materials can overcome scientific and technological problems relevant to personal protection against phosphorus- and/or sulfur-based nerve agents.

Laboratory scale sheets consisting of metal-oxide nanofibers have been generated by using a rotating drum apparatus for collecting non-woven electrospun nanofibers in the form of a long continuous sheet. The fibers in these sheets are randomly oriented, producing a nonwoven fabric-like material that is flexible and somewhat elastic. In one embodiment this is a macroscopically large piece of material, composed entirely of nanoscopically small (in diameter) polymer nanofibers. This approach is extended by using a segmented drum, which consists of sets of equally spaced wires grounded to create the large potential difference with respect to the spinnerette tip. The materials generated achieve partial orientational alignment of the nanofibers within the sheet over shorter periods of time. For longer periods of time, the fibers start spinning in random patterns and alignment is gradually lost. These aligned mats are thick enough to cut and handle.

Structures (such as fabrics and filters) composed of aligned nanofibers will have properties (thermal, mechanical, mass transport, etc.) superior to those formed from non-woven materials. Using combinations of aligned and random regions, one can tailor nanofiber sheets for specific applications. In this instance, one aims for materials that enable phosph(on)ate aerosol capture and decomposition while permitting water vapor exchange. In the case of filtration media, the nanofibers may also require additional structural support. Titania nanofibers are formed by coating polymer nanofibers with sol-gel precursors followed by heat treatment, and then taking sheets of polymeric nanofibers and transforming them into metal oxides. The next step incorporates long polymer nanofibers into micron-sized glass-fiber filter media

using a vacuum molding method. The mixed fibers are easily vacuum molded into porous disks 1 cm thick and 6 cm in diameter. For structural strength an acrylic binder is used to hold the fibers together. The ability to produce nanofibers from materials by electrospinning and subsequent coating or thermal processing, combined with the in-house expertise to form filtration media from the resulting materials, offers great potential for the decomposition of phosphorus-based nerve agents.

The length and diameter of the generated nanofibers is dependent on the conditions under which the fibers are produced. The experimental parameters of polymer concentration, metal-oxide precursor concentration, mole ratios, polymer molecular weight, applied potential, distance between sample and collector plate, solution flow rate, humidity and temperature impact the final product. Each of these parameters has been investigated and is being optimized to produce the desired nanofiber characteristics.

Applications of Nanofibers

Clothing and breathing filters that adsorb or absorb and then decompose phosph(on)ate species are now possible. Lightweight ponchos made of thin polymer sheets containing nanofibers or nanoparticles can be folded and conveniently carried and stored. The immediate availability of such protection provides reassurance to reduce the spread of panic in the event of a terrorist attack involving civilians. The incorporation of metal oxide nanofibers and nanoparticles into polymer nanofiber structures is important. The polymer nanofibers bind the metal oxide materials together, forming a flexible system that does not pose a threat of skin irritation or asbestosis. The solubility of the phosph(on)ate species causes certain polymers to swell via absorption, trapping the toxic compounds at a high rate and then allowing for chemical detoxification via the metal oxide surfaces in intimate contact with the polymers.

Electrospinning Development

Electrospinning is an electrohydrodynamical process for making thin polymer fibers with diameters in the range from around one nanometer to several thousands of nanometers. The low capital cost and the simplicity of equipment needed to make polymer nanofibers has enabled scientists and engineers in fields such as filtration, biomaterials, biomedical devices, chemical analysis, catalysis, aerospace, fiber reinforced composites, energy conversion, protective clothing, agriculture, and others to produce experimental quantities of nanofibers from a wide variety of polymers. Nearly any material can be incorporated into the nanofibers. The current invention builds upon current work in state-of-the-art electrospinning processing and materials characterization relevant to phosphorus compounds adsorbed on metal oxides.

Visualization and Modeling of Electrospinning Dynamics

The production of large quantities of nanofibers with well-defined and uniform properties is a problem confronting the emerging uses for polymer nanofibers as reliable adsorption and decomposition of nerve agents depend on the production of nanofibers with well-controlled properties. Controlling the electrospinning process is critical. Improved visualization techniques include the observation of interference colors in jets with diameters ranging from the wavelength of light to more than 10 microns. This being a critical range, often including the onset of the electrically driven bending stability. These observations of the diameter are made on both the straight segment of the jet and the moving coils of an elongating and bending jet, by recording the colors with a digital video camera.

The jet is illuminated with a cone of white light that converges on the sample as illustrated in Figure 10. The viewing axis is a few degrees off the axis of the cone of illumination in a plane that is perpendicular to the direction of the straight segment of the jet. Colors are seen in a range of angles near 5 degrees, but the exact relationship between the color and the jet diameter depends on this angle.

Figure 10 is a scaled diagram of the experimental arrangement detailing the light path. The distance from the light source to the camera is about 2 meters, so that the photographic apparatus does not affect the electric fields near the jet. The colors are not the spectral colors seen with a prism, but a complex mixture of interference colors similar to the pastel shades seen in a soap bubble. The camera is focused on the jet.

Figure 11 shows a series of images from a video sequence of a jet that was "dying" after the voltage was suddenly reduced to a value at which the jet would no longer flow. Measurements of the diameter, of each segment having a recognizable color, by observing the diffraction pattern of laser light, established the diameter corresponding to the various colors. Calibration is only required once for a particular arrangement of the camera and the spectral distribution of the white light. The blue band, in the envelope cone, details the location where the diameter of the jet becomes smaller than the wavelength of light, which is between 300 and 400 nanometers.

This series of images demonstrates the diameter and taper rate of the jet measured rapidly, and an experienced observer can, for example, interpret changes in diameter "on the fly" as voltage or other experimental parameters are changed. The photographic record contains a wealth of detailed information about changes in jet diameter as a function

of time. Video images of jets disturbed by rapidly passing a glass rod through the jet can be analyzed to show the changes in diameter of the entire jet. This new capability is providing information needed to compare the calculated and experimental behavior of the jet in response to changes in process variables, on a time scale of about 16 ms.

Various stereographic, high frame rate, short exposure time photographic arrangements are also used to provide detailed three dimensional measurements on the path of the jet, and changes in the path. Information about the time evolution of the location, trajectory, and shape of many segments of the jet is collected, processed and stored digitally. This information shows the response of the spinning jet to variations in the values of particular process parameters, in the half-dozen or so inter-related parameters used to describe the process. These efforts producing information resulting in large improvements in the uniformity of the nanofibers that are produced. Control over nanofiber properties is critical for systems that reliably adsorb or absorb and then decompose nerve agents.

The formation of "garlands" are produced when loops of the fluid jet cross, come into contact, and join together at the crossing point. A long, complicated chain of such loops is formed from polylactone and other polymers, in a certain reproducible range of processing conditions. Similar observations relevant to the formation of lateral branches on jets are noted. These detailed observations support the theory that although the behavior of an electrospinning jet is quite complicated, it is amenable to a much higher degree of control than is presently applied.

The successes in making detailed measurements of the path of the jet, in three dimensions, as a function of time, have allowed for ways to control more aspects of jet behavior, so that more sophisticated nanofiber structures can be manufactured in cost-effective ways as mathematical models will be compared with detailed measurements of the onset of the electrically driven bending instability.

<u>Nanofiber Filtration and Alignment Efforts</u>

The activities in the area of coalescence filtration are presently centered on observation of rates at which droplets of oil in air come into contact with and become attached to polymer nanofibers. The droplet may sometimes be smaller in diameter than the nanofibers, however, the droplets are typically smaller than the microfibers (5 microns in diameter), but larger than the nanofibers (100 nm in diameter). Figure 12 below is from a set of experiments in which the growth in diameter of droplets on nanofibers is used to measure the rate of attachment. These data are used to understand how small droplets interact with nanofibers - via diffusion or impact. This information being relevant to the capture of aerosol nerve agent species.

To generate large fabrics and enable the production of anti-g-agent garments and filters, it is necessary to develop techniques for scaling up the electrospinning process for metal oxide nanofibers. To prove this concept a rotating drum was designed and constructed for collecting non-woven electrospun nanofibers in the form of a long continuous sheet.

Figure 13 shows that such methods can be used to produce materials in sufficient quantities for testing phosph (on)ate adsorption. The fibers in this sheet are randomly oriented, producing a nonwoven fabric-like material that is flexible and somewhat elastic. Note that this is a macroscopically large piece of material, composed entirely of nanoscopically small (in diameter) polymer nanofibers. This approach can be extended using a segmented drum, with the results indicating success in achieving partial orientational alignment of the nanofibers within the sheet. The segmented drum consists of sets of equally spaced wires grounded to create the large potential difference with respect to the spinnerette tip. As the polymer spins, it aligns across the copper wires.

The electrospinning for these experiments is conducted at various time increments to study the effect of layering and any noticeable threshold limit on the amount of fiber that can be spun before entanglements are noticed. As seen in the scanning electron microscope (SEM) images in Figure 14, good alignment is present up to approximately fifteen minutes of spinning. These aligned mats are thick enough to cut and handle. For longer periods of time, the fibers start spinning in random patterns and alignment is gradually lost.

One hypotheses involves structures (such as fabrics and filters) composed of aligned nanofibers having properties (thermal, mechanical, mass transport, etc.) superior to those formed from non-woven materials. Using combinations of aligned and random regions, one can tailor nanofiber sheets for specific applications. The goal becomes materials that enable phosph(on)ate aerosol capture and decomposition while permitting water vapor exchange.

Another hurdle involves how to structurally support metal oxide nanofibers within filtration media. It is known in the field of invention how to form titania nanofibers by coating polymer nanofibers with sol-gel precursors followed by heat treatment. Therefore one can take sheets of polymeric materials like those of Figures 13 and 14 and transform them into metal oxides. Prior studies incorporated long polymer nanofibers into micron-sized glass-fiber filter media using a vacuum molding method. The mixed fibers are easily vacuum molded into porous disks 1 cm thick and 6 cm in diameter (see Figure 15). For structural strength an acrylic binder is used to hold the fibers together.

Relevant Metal Oxide Efforts

As noted previous, nano-scale metal oxides offer advantages for the chemical detoxification of nerve agents. The recent synthesis of titania nanofibers and those modified with erbia are described. This work demonstrates the ability to form metal oxide nanofibers and modify them as required. The production of alumina and magnesia nanofibers for nerve agent detoxification follows the same processing steps and chemistry described below, applied to additional metal oxide precursors. The incorporation of metal oxide particles into a metal oxide nanofiber matrix is also demonstrated. This indicates that one can include metal oxide particles into nanofibers of other oxides or polymers. This leads to unique fabrics and filters for personal protection from nerve agents.

Synthesis and Characterization of Titania Nanofibers

For the fibers discussed herein, tetraisopropyl titanate (TPT) (TYZOR TPT, from Dupont) was mixed with a 10% solution of polyvinylpyrrolidone (PVP) (average MW 360,000 from PolySciences, Inc.) in absolute ethanol. The mixture ratio of TPT to the PVP solution was varied from 0.008 to 1.38 by weight in order to optimize the electrospinning process for nanofiber production. Metal washers or aluminum foils were used as the collectors during spinning. The fibers were hydrolyzed in air for 12 hr and then heated in air to pyrolize the PVP. For erbia-doped titania nanofibers, a 0.4 TPT:PVP weight ratio was used with erbium (III) oxide particles (Strem Chemical, Inc.) added to the solution before electrospinning. Fibers made using an erbia:TPT ratio of 1.0 by weight were produced and used in the following experiments.

An SEM image of titania fibers after pyrolysis is shown in Figure 16 for a TPT:PVP precursor weight ratio of 0.8. This ratio plays an important role in determining the diameters of the resulting fibers. At a very low (0.008) TPT: PVP ratio, continuous titania fibers cannot be produced by electrospinning. A TPT:PVP ratio of 0.02 is an optimal ratio for forming titania nanofibers that can survive pyrolysis under the conditions discussed here. Increasing the TPT:PVP weight ratio leads to an increase in the diameter and structural homogeneity of the titania nanofibers as seen in Figure 16 for a 0.8 weight ratio. Increasing the TPT content further leads to fibers with diameters in the micron range. Prior work demonstrates control of the electrospinning conditions to adjust properties of the resulting nanofibers, a skill used to reach the goal of nanofiber systems for nerve agent detoxification.

Titania has brookite, anatase and rutile crystal structures. In order to ascertain the phases present, titania nanofibers were ground into powders and X-ray diffraction (XRD) measurements were performed. As shown in Figure 17, the resulting Bragg peaks are intense. Annealing at 773 K in a sintering furnace pyrolyzes the PVP leaving anatase phase titania nanofibers as indicated by the lower diffraction pattern. Increasing the annealing temperature to 1173 K produced rutile-phase titania nanofibers as indicated by the upper diffraction pattern. The major diffraction peaks are labeled using the notation A(hkl) and R(hkl), where A and R, respectively, stand for anatase and rutile, and the integers h, k, and l are Miller indices. This demonstrates the ability to control the crystal structure of the metal oxide nanofibers produced.

As shown in the SEM images of pyrolyzed erbia-doped titania nanofibers in Figure 18, the fibers both support larger erbia particles (left), and encapsulate smaller erbia particles (right). This provides significant flexibility in nanofiber development. In Figure 18 the titania nanofibers have very large length to diameter ratios and form a random nonwoven mat with many pores for gas to flow through. The ability to incorporate metal oxide particles into other metal oxide nanofiber matrices is used in the effort to develop materials for garments and breathing apparatus that decompose phosphorus-based nerve agents.

X-ray photoelectron spectroscopy (XPS) measurements characterize the chemical composition of the surfaces of our titania nanofibers. Survey scans of pyrolyzed titania nanofibers and of those incorporating erbia particles are presented in Figure 19. These spectra have been vertically separated for clarity but no background fitting has been performed. As expected, all the fibers contain Ti, O, and C, and the upper spectrum shows the presence of erbium as well.

Synthesis of Metal Oxide Fibers

Two main techniques to produce metal oxide nanofibers are widely used. One is the direct electrospinning of solutions that include both polymer and metal oxide precursors, followed by thermal treatment and the other involves the electrospinning of polymers only, followed by coating with metal oxides by physical or chemical vapor deposition or sol-gel techniques. The third method recently developed and described previous for nerve agent detoxification incorporates metal oxide nanoparticles and nanofibers into composites with absorbent polymer nanofibers.

For all three methods, understanding the relationship between the electrospinning conditions and the resulting fiber characteristics is important. As described previous, a thorough understanding of the electrospinning process uses sophisticated visualization techniques. One combines the results from these visualization experiments with the characterization of the resulting fibers to develop a more complete understanding of how to control nanofiber size and shape.

For example, Figure 20 provides experimental results indicating that as gap distance (the distance between the high voltage spinnerette and the grounded collector plate) increases, the fiber diameter decreases. In addition, as the polymer concentration increases the fiber diameter increases. The gap distance affects the electric field and the time available for elongation of the jet and solvent evaporation. Solvent concentration affects the viscosity of the fluid jet, the evaporation rate, the elastic modulus of the jet, and possibly the amount of charge on the jet. Through the combined effect of all these parameters the solvent concentration influences the final fiber size and shape.

As described previous, changes in the electrospinning process effect the resulting nanofiber characteristics including the surface structure. This is important for the directly-spun metal oxide nanofibers as well as for those formed by coating polymer nanofibers. Extensive work occurred with nanofibers as substrates for coatings of many materials. For example, nanofibers of MPD-I, a high performance polyamide, with an average diameter of 100 nm are coated using chemical and physical vapor deposition techniques. Also, fibers have been coated with metals, oxides, and nitrides. As an example, Figure 21 shows fibers coated with aluminum nitride (a wide band gap semiconductor) by a reactive sputtering physical vapor deposition technique.

The pressure, power, and substrate to target distance were controlled such that the transport of depositing species was by diffusion in each case. As shown in Figure 21, different sets of fibers have different surface morphologies as a result of controlling the deposition conditions. Pyrolysis of the polymer core shows that the coatings were continuous around the fibers. The different surface morphologies result from different types of defects within the coating. These same types of defects effect the adsorption and decomposition of phosph(on)ates. The core nanofiber surface morphology and composition are modified so that the roughness, chemical stability, wettability, conductivity and other physical properties of the coated surface are controlled. Additional work continues along these lines with metal oxide materials to develop high surface area nanofiber structures that are effective for phosph(on)ate decomposition.

Synthesis of Metal Oxide Nanofiber Sheets

One embodiment of an adsorbent system that forms large nanofiber sheets or mats is titania. The direct method of electrospinning titania nanofibers and their characterization was discussed previous. The other method utilizes coatings of polymer nanofiber sheets followed by pyrolysis of the polymer substrate as described previous. Sheets of titania nanofibers approximately 15 cm by 50 cm are electrospun from multiple tips and collected on a rotating drum. This provides sufficient quantities of material for parallel studies of fiber structure, stoichiometry, and reactivity toward phosph(on)ates.

Nano-scale particles of magnesia and alumina are incorporated into the titania nanofibers, and characterized for surface reactivity and morphological structure. In addition, one incorporates metal oxide nanoparticles into nanofibers made from polymers swollen by phosph(on)ate exposure. In this third method the polymer absorbs the phosph(on)ate which is then detoxified by the nearby nanoscale metal oxide materials. It is possible that certain combinations of nanofibers with nanoparticles synergistically provide even higher surface reactivity toward phosph(on)ate decomposition than either material system can provide independently. The literature indicates nanoparticles of alumina and magnesia dissociate the phosphorus compounds of interest, but it is not known if encapsulating or supporting them with nanofibers will enhance or degrade their performance in this regard. Additional work follow methods similar to those used in titania nanofiber synthesis development to create continuous nanofibers of magnesia and alumina for testing.

Characterization of Metal Oxide Nanofibers

Critical to producing the optimal metal oxide nanofibers for the decomposition of nerve agents and their simulants is a detailed understanding of the composition and structure of the nanofibers, decomposition mechanisms and rates of decomposition of nerve agent simulants, and the loading capacity of nanofibers exposed to simulants. These parameters depend on the nanofiber synthesis process and conditions. Fibers, processed under varying conditions as described above, are characterized using SEM (morphology), XRD and TEM (structure), XPS (surface composition) and solid-state NMR (SSNMR, active site structure and density). In addition, upon reacting the fibers with nerve gas simulants the reaction products are monitored by SSNMR and FTIR. Nerve agent simulants studied in this effort are diethyl 4-nitrophenylphosphate (paraoxon), diisopropyl fluorophosphate (DFP), dimethyl methylphosphonate (DMMP), and methyl dichlorophosphate (MDCP).

Surface Characterization

The high reactivity of nanoparticle metal oxides is proposed to arise from the large number of defects sites present on the surface. These defects sites can be made prevalent on nanofibers with high surface area and small diameter by control of the processing conditions. Characterization of the surface metal sites provides chemical details of the sites with which the simulants react. The following discussion of NMR characterization of metal oxide nanofibers

focuses on alumina, but similar studies also occur for titania and magnesia fibers. The application of cross-polarization, magic-angle spinning, high field and multiple-quantum techniques yield high-resolution spectra. NMR (isotope $^{27}Al$) studies of alumina nanopowders revealed the presence of both tetrahedral and octahedral alumina sites in the bulk material. Only the surface alumina sites are selected for characterization by using $^{1}H$ - $^{27}Al$ cross-polarization. With this technique only those alumina sites close to a proton (surface hydrogens) give rise to signal in the NMR spectrum. Studies of alumina nanoparticles show that octahedral sites dominate the surface and are reactive towards g-agents and VX.

The surface composition of the nanofibers are characterized by using $^{1}H$ - $^{27}Al$ cross-polarization to determine the structure and distribution of the surface alumina sites before adsorption of the simulants. This characterization is extended to monitor the alumina sites involved in direct interaction with the simulants. After exposure, the alumina sites that reacted with the simulant are characterized using $^{31}P$ - $^{2}7Al$ cross-polarization technique. This approach allows for the determination of the types of metal oxide sites that react directly with the simulant. The $^{27}Al$ NMR data is combined with the $^{31}P$ data to correlate the nanofiber surface structure and stimulant hydrolysis activity. This information is used to determine the optimal synthesis procedure in an iterative manner (synthesize, characterize, optimize).

The surfaces of nanofibers are characterized by XPS, which is used to determine the oxidation state of metal atoms in the metal oxide nanofiber systems as well as the binding of phosph(on)ate species. Semi-qualitative analysis of survey scans and quantitative analysis of high-resolution spectra are performed in a manner complementary to the SSNMR efforts, as one uses Al, Mg and Ti anodes as X-ray sources to help distinguish unknown features if necessary. Results of these surface characterization efforts are used to improve the nanofiber synthesis procedures in an iterative fashion.

## Phosph(on)ate Uptake Capacity

Another important property of the metal-oxide nanofibers studied is their uptake capacity or maximum loading level of nerve agents and simulants. Loading levels are determined using UV/vis or IR, depending on the absorption values of the simulants. For simulants with a large absorbance in the UV/vis region (*i.e*. paraoxon), nanofibers are added to a volume of pentane (or other suitable solvent) and the simulant. At periodic time intervals, a sample of the solution is removed and its UV/vis spectrum collected. The absorbance from the simulant remaining in solution is used to determine the concentration, which yields the amount of simulant adsorbed to the nanofibers. Simulants having small extinction coefficients will be characterized by vapor-phase IR. Nanofibers are placed into a vapor-phase IR cell and then the simulant is added to the cell. IR spectra are collected over a 24 hr period, and based on the intensities of the features related to the unbound simulant species, one determines the amount of bound simulant per gram of nanofiber. Similar uptake experiments using liquid cell IR combined with attenuated total reflectance and diffuse reflectance techniques are performed.

The actual loading level of the fibers may be significantly larger than the initial loading level if the bound organophosph(on)ates result in dissolution of the metal oxide. NMR studies of mono-stearyl acid phosphonate adsorbed on alumina and VX, GB and GD adsorbed on alumina nanoparticles indicate that bulk alumino-organophosphates are formed. In these materials, after reacting with organophosphates, reactive surface sites are regenerated and the metal oxide is active towards organophosphate decomposition until consumed. The nanofibers are characterized spectroscopically to determine if dissolution is occurring and the rate at which it occurs. Solution studies are also performed to determine the total long-term loading levels of the nanofibers.

## Mechanisms of Phosph(on)ate Decomposition on Metal Oxide Nanofibers

The mechanisms of phosph(on)ate decomposition involve several steps that are elucidated spectroscopically here. Specifically one looks for evidence of dehalogenation and ester cleavage from the phosphorus moieties due to adsorption, poisoning or fouling mechanisms that lead to decreased surface reactivity of the nanofibers, and the structure of the reactive metal oxide sites. Although the surface chemistry of the simulants used in this study do not exactly model that of actual nerve agents, these analog compounds permit us to determine whether or not the metal oxide nanofiber materials have the potential to dissociatively adsorb g-agents and VX.

The hydrolysis reactions of the simulants that occur on metal oxide surfaces are monitored by SSNMR as reported previously. For example, it has shown that the reactivity of nerve agents and simulants on metal oxide powders is heterogeneous. On MgO, GD and VX undergo complete hydrolysis of the P-F and P-S bonds, respectively. Hydrolysis of the P-O bond is only partially complete for both organophosphate compounds. When bound to alumina, only hydrolysis of the P-F and P-S bonds are observed. Studies of the reactions of the simulants paraoxon and DFP again show that the reactivity is metal oxide dependent. On alumina the P-F bond is completely hydrolyzed, however, on MgO the simulants are hydrolyzed completely to $PO_4^{-3}$. The $^{31}P$ chemical shifts easily discern phosphorus bound to 2, 3 or 4 oxygens and will be used to determine whether one, two or three hydrolysis steps have occurred and the extent of each reaction. The byproducts of the hydrolysis reactions will be monitored by $^{13}C$ and $^{19}F$ NMR.

Rate of Decomposition of Simulants on Nanofiber Materials

The rate of decomposition of nerve agent simulants on the nanofibers are determined by two different methods. The solution rate of reaction is determined from the UV/vis and IR data discussed above (uptake capacity). The reaction rate is calculated from the absorbance changes of the simulants in solution versus time. The second method is to determine the rate of decomposition when the simulant reacts directly with the nanofibers, in the absence of a solvent. The nerve agent stimulant is added directly to the nanofibers and solid-state $^{31}P$ and $^{13}C$ NMR is used to follow the reaction. The reaction rates determined by this method are complicated as they are a function of both the rate of the decomposition reaction occurring at the nanofiber surface and the diffusion rate for the simulant to reach the surface. However, comparisons of different materials provide insight needed in the nanofiber optimization.

Filtration Studies

Successful adaptation of the oxide nanofibers for decomposition of, and ultimate protection from, nerve agents require fabrics that are mechanically stable and porous enough to allow the soldier or civilian to breathe easily. Prototype filter structures are made from the most-promising nanofibers and tested to determine flow resistance and water vapor exchange properties. Currently, the pilot scale coalescence filter test apparatus has a Laskin Nozzle for generating oil droplet aerosols with droplets primarily in the 100 to 300 nm range. The aerosol is used to challenge filter samples (6 cm diameter disks) held in a filter holder. Droplet concentrations upstream and downstream of the filter are measured with a TSI SMPS 3934, capable of measuring drops in the diameter range from 60 to 1000 nm. Pressure drop is measured across the filter sample, and the flow rate is controlled using a rotameter. This apparatus is modified and used to perform preliminary studies of mild or dilute phosph(on)ate aerosols in a proof-of-concept approach.

A typical experiment exposes the filter media to a dilute aerosol and measures the pressure drop and droplet concentration across the filter media, then combines these measurements with characterization of the outlet stream to determine the species present. Depending on the results of these proof-of-concept tests one makes modifications to the prototype device to improve performance. For example, if the pressure drop is too high one increases the percentage of large glass fibers within the filter media used to support the metal oxide nanofibers. If the droplet concentration is too high on the downstream side of the test cell one changes the distribution of fiber sizes depending on the size of the droplets being observed. Typically, the required fiber size for capturing droplets correlates directly with the size of the droplets to be captured. If too many small droplets (< 70 nm) are getting through the filter media one increases the ratio of small oxide fibers (< 70 nm) in the filter media. Finally, if phosph(on)ates are detected in the outlet stream one either increases the ratio of metal oxide nanofibers in the media or changes the type of nanofiber.

Synthesis and Characterization of Alpha-Phase Aluminum Oxide Nanofibers

Aluminum oxides, hydroxides and oxyhydroxides, upon heating, pass through several metastable intermediate phases (transition aluminas) before transforming into the thermodynamically stable corundum phase ($\alpha$-$Al_2O_3$). Because of their high surface area, mixture of acid-base properties, and surface hydration/hydroxylation mechanisms, these transition aluminas are industrially important as adsorbents and catalytic materials in hydrocarbon cracking, purification of gas oil fractions, control of combustion emissions, destruction of chemical weapons and other chemical processes. The dominant alumina phase used in these applications is $\gamma$-alumina, due to its ease of formation by simply heating the boehmite phase to 400-450˚C and because of its large surface area and reactivity. In an effort to enhance the chemical properties of alumina, mesostructured and nano-scale aluminas have been synthesized by a variety of techniques. Alumina nanoparticles typically have diameters <10 nm and lengths of a few hundred nm, as well as moderately high surface areas. In one case alumina nanorods with a length of -5 um and an aspect ratio of 25-250 were generated.

Electrospinning techniques have been utilized in an effort to generate metal-oxide nanofibers with small diameters (i.e., high surface areas) and large aspect ratios (easily handled bulk materials). In this technique a polymer precursor solution in a pipette is held at a high (kV) potential relative to a nearby grounded plate. A charged jet of the precursor solution is ejected from the pipette as a result of the applied electric field. Rapid evaporation of the solvent results in the collection of polymer fibers with diameters less than 2 $\mu$m.

Using the aforementioned electrospinning method, followed by thermal processing, aluminum oxide nanofibers have been produced, yielding nanofibers with high aspect ratios of greater than one thousand. These fibers combine both a high surface area with macroscopic handling capabilities. The synthetic approach to these fibers has the potential of providing alumina fibers with interesting and enhanced catalytic and adsorbent properties, when compared to other alumina structures. This report describes the first detailed characterization of the structure, composition and surface reactivity of a metal oxide nanofiber produced by electrospinning.

Experimental Apparatus and Design: Chemical used

Aluminum acetate stabilized with boric acid was purchased from STREM chemicals. Polyvinylpyrrolidone (PVP) was purchased from Sigma-Aldrich. 200 proof, absolute ethanol, purchased from pharmco products, inc. was used as the solvent in the nanofiber formation. Aluminum oxide powder ($\alpha$-$Al_2O_3$, < 10 $\mu$m) was also purchased from Sigma-Aldrich. All materials were used as received.

Aluminum Oxide Nanofiber Formation

Aluminum acetate stabilized with boric acid was mixed with 10% polyvinylpyrrolidone (PVP) in ethanol. The ratio of aluminum acetate to the polymer solution was varied at fixed spinning conditions. The mixtures were placed in a pipette and electrospun using an electric field of 1 kV/cm. Grounded aluminum foil was used as the collector during the spinning process. The fibers were then heated in air at various temperatures and characterized accordingly.

The aluminum acetate mixture was made with a 5g:10ml:13 ml ratio of aluminum acetate, water and ethanol and kept overnight to let the mixture dissolve completely. The polymer solution was made with a 1g:10ml ratio of polyvinylpyrrolidone (PVP) to ethanol. Different ratios of aluminum acetate to polymer solution were mixed and it was found that a 1:1 solution provided optimal nanofiber formation.

The electrospinning apparatus includes a sheet of aluminum foil wrapped around a conducting material with a grounded wire attached to the foil in order to ground the collection area. The spinning solution was placed into a pipette and a copper wire (attached via a power supply cable) was placed into the wide end of the pipette. The power supply was turned to a voltage of 25 to 30 kV in order to charge the solution and produce fibers. The collected fibers were then heated to remove the guide polymer from the materials. The polymer begins to pyrolized at about 400˚C, leaving behind aluminum oxide nanofibers.

Scanning Electron Microscopy (SEM)

SEM was performed on a JOEL JEM-5310 instrument and operated at 25 kV and 60 mA. A sample of the fiber was placed on a doubled-sided conducting carbon tape, attached to the sample holder. It was then coated, via sputtering with a very thin layer of Pd alloy, making the surface electrically conductive, while keeping the features of the sample unaltered.

The chamber was vented and the sample was placed in the chamber. Then the chamber was placed in low vacuum mode and voltage as high as 25kV was run through it for sputtering Pd alloy. Next, the SEM images were taken at varying magnification in order to show the surface characteristics of the fibers. All of the data was saved. To finish, the system was vented, the samples removed and the system left in high pressure mode.

Infrared Spectroscopy

Fourier transform infrared spectroscopy was performed on a Bruker IFS 66v/s spectrometer, using a Harrick "praying mantis" diffuse reflectance accessory. A broadband mercury-cadmium-telluride detector, SiC source and a KBr beam splitter were used. The spectra were recorded using $2cm^{-1}$ resolution and 1024 scans were averaged. All experiments were done under vacuum, with a pressure of less than 5 mbar.

X-ray Photoelectron Spectroscopy(XPS) and Secondary Ion Mass Spectrometry(SIMS)

XPS and SIMS measurements were performed in a VG ESCALAB Mk II system under high vacuum conditions. The aluminum anode on a dual anode (Mg/Al) X-ray source was used for XPS with a power of 180 W. The analyzer had a fixed transmission energy of 50 eV for survey scans and 20 eV for most of the detailed scans. Positive and negative ion SIMS was performed with a 3keV $Ar^+$ ion beam and a MM12-12 quadrupole mass spectrometer.

Solid-State Nuclear Magnetic Resonance Spectroscopy

$^{27}Al$ spectra were collected on a Varian Unityplus 750 MHz (17.61T) spectrometer using a Doty Scientific DSI-971 Narrow Bore Cross-polarization Magic-Angle Spinning (CP/MAS) probe. The samples were packed into 4 mm silicon nitride rotors with aurum end caps. Simple one pulse (bloch decay) experiments were performed with a spinning speed of 13kHz. The $^{13}C$ spectra were collected on a Varian Unityplus-200 (4.7 T) spectrometer using a Doty Scientific Variable Temperature Magic-Angle Spinning (VTMAS) probe. Cross-polarization and magic-angle spinning were used to obtain the $^{13}C$ spectra, using a 2 ms cross-polarization time and a spinning speed of 5 kHz. The $^{13}C$ chemical shifts were referenced to TMS and the samples were packed into 7 mm silicon nitride rotors with Kel-F end caps.

Experimental Results

Nanofibers of polyvinylpyrrolidone (PVP), with average diameters of 500 nm, fabricated using the aforementioned electrospinning technique are shown in the scanning electron micrograph (SEM) image in Figure 22. When the fibers are spun from a solution containing aluminum acetate, the polymer fibers are impregnated with aluminum acetate.

The $^{13}C$ solid-state NMR spectra from these fibers, Figure 23, show that neither the polymer nor the aluminum acetate undergoes any reactions during the fiber formation process. Removal of some or all of the sacrificial polymer (PVP) is accomplished by annealing the fibers at temperatures up to 1200˚C. At this temperature the polymer is completely decomposed as evidenced by the disappearance of its $^{13}C$ NMR spectrum, see Figure 23D.

The NMR findings agree with what is seen in the TGA measurements in Figure 24, in that significant weight loss is observed upon annealing the fibers at temperatures above 525˚C.

The high-field $^{27}Al$ NMR data shown in Figure 25 also indicates that the aluminum site does not undergo change during electrospinning. Upon heating the fibers to 1200˚C, the spectrum contains peaks at 15 ppm from the octahedral ($O_h$) sites and 70 ppm from the tetrahedral ($T_d$) sites (Figure 25D) and is nearly identical to that observed for $\alpha$-alumina particles (Figure 25A). The change represented in the spectra, upon thermal treatment show that alumina nanofibers have been generated and their bulk structure is similar to that of the $\alpha$-alumina powders.

The diameter of the fibers generated by heating to 1200˚C is little changed from the as-spun fibers, as determined from SEM micrographs. However, the very large aspect ratios are reduced, and the fibrous material is considerably more brittle than the as-spun aluminum acetate/PVP fibers.

XRD measurements also confirm that the nanofiber samples, after annealing are predominantly alpha- phase alumina, however small traces of boron are detected, as seen in Figure 26. The presence of boron is not surprising and arises from the 2.7 wt. % boric acid present in the aluminum acetate.

The data described thus far has provided insight as to the bulk structure of the aluminum oxide nanofibers; however, it is the composition of the surfaces of these nanofibers that is critical in determining their chemical reactivity. Using $^{1}H$ - $^{27}Al$ cross-polarization NMR only the aluminum atoms that are near protons; i.e. at the surface of the nanofibers are depicted. The CP spectrum shows a weak signal indicating a low population of surface hydroxyls, consistent with previous studies of $\alpha$-alumina materials with low surface areas.

Upon performing SIMS, it is apparent that these nanofibers contain sodium, which is due to the composition of the aluminum acetate used in the processing (contains about 2 wt. % Na). However, SIMS is a surface sensitive technique, and although the overall amount of sodium in the starting solution is small by weight, segregation phenomena during crystallization can enrich the nanofiber surfaces with impurities, as evidenced by Figure 27.

Such findings are corroborated by XPS survey scans of as-spun nanofibers and from those heated to 1200˚C (Figure 28). The rationalization to these results involves the fact that heating pyrolyzes the PVP, and thus the nitrogen and carbon signatures substantially decrease in relative intensity. After annealing, the atomic % composition determined by XPS is 10.8 % Al and 6.3 % Na, indicating that the surface is substantially enriched by sodium. In addition, 3.2 at. % of the surface of the fibers is composed of boron, which is much larger percentage wise than would be expected from the boric acid adduct present in the aluminum acetate at 2.7 wt. %. This demonstrates that care must be taken to spectroscopically characterize ceramic nanofibers electrospun from metal-organic precursors, in order to insure that their surfaces will exhibit the anticipated chemical reactivity.

It is however the results from diffuse reflectance IR spectroscopy (DRIFTS) that clearly defines the aluminum oxide nanofibers, as unique. In Figure 29, the as-spun nanofibers exhibit IR bands of PVP and aluminum acetate, consistent with the NMR results of Figures 23 and 25, indicating that no chemistry occurs during electrospinning. After heating, the nanofibers produce an IR spectrum that differs from $\alpha$-alumina powder. Modes in the 1300-1500 $cm^{-1}$ region due to borates, and well-developed hydroxyl bands that are not present in the powder, appear in the spectrum. These latter hydroxyl bands indicate that the surface site distribution of the nanofibers differs from that of the powder. This is believed to be due to defects generated during the morphological changes that occur during heating and removal of the PVP, to the sodium and boron impurities that populate the surface of the nanofibers, or to the confined geometry of the alumina crystallites within the nanofibers.

The Fabrication of Alumina Fibers with Unique Structures and Composition

As alluded to previous, aluminum oxides, hydroxides and oxyhydroxides, such as Gibbsite ($\gamma$-$Al(OH)_3$), Bayerite ($\alpha$-$Al(OH)_3$), Nordstandite ($Al(OH)_3$), Boehmite (y-AIOOH), Diaspore ($\alpha$-AlOOH), upon heating, pass through several metastable intermediate phases (transition aluminas) before transforming into the thermodynamically stable corundum phase ($\alpha$-$Al_2O_3$). Several of these phase transition pathways are shown below:

$$\text{Bayerite} \xrightarrow{230^\circ C} \eta \xrightarrow{850^\circ C} \theta \xrightarrow{1200^\circ C} \alpha\text{-}Al_2O_3$$

$$\text{Boehmite} \xrightarrow{450^\circ C} \gamma \xrightarrow{750^\circ C} \delta \xrightarrow{1000^\circ C} \theta+\alpha \xrightarrow{1200^\circ C} \alpha\text{-}Al_2O_3$$

Equation (5)

These materials have different crystal structures as well as differences in the fraction of 4, 5 and 6-coordinate aluminum sites. Because of their high surface area, mixture of acid-base properties, and surface hydration/hydroxylation mechanisms, these transition aluminas are industrially important as adsorbents and catalytic materials in hydrocarbon cracking, purification of gas oil fractions, control of combustion emissions, destruction of chemical weapons and related toxins, and other chemical processes. The dominant alumina phase used in these applications is $\gamma$-alumina due to its high surface area and reactivity, and this phase is readily generated upon heating the Boehmite phase to 400-450°C. In an effort to enhance the chemical properties of alumina, mesostructured and nanoscale aluminas have been synthesized by a variety of techniques. These nanoparticles typically have diameters < 10 nm and lengths of a few hundred nm, however, in one case alumina nanorods with a length of -5 $\mu$m and an aspect ratio in the range 25-250 were generated. These materials have moderately high surface areas.

While nanoparticles of alumina do offer high surface areas, they suffer from difficulty in handling. The small particles size makes recovery of the nanoparticles through methods such as filtration very difficult. Also, integration and retention of the particles into other materials, such as textiles, is hindered by the difficulty of keeping the nanoparticles localized. The formation of nanometer diameter alumina fibers that can be readily handled and provide the desired catalytic and structural properties is ideal.

As an extension of efforts in electrospinning novel materials, there have been recently developed methods of producing aluminum oxide nanofibers. This method produces aluminum oxide nanofibers in a single electrospinning step followed by thermal processing, yielding nanofibers with aspect ratios in excess of 10. These fibers combine both a high surface area with macroscopic handling capabilities (> 100 $\mu$m long fibers). The unique synthetic approach to these fibers produces materials with different surface and bulk structures and composition when compared to other alumina structures, which may produce alumina fibers with interesting and enhanced catalytic and adsorbent properties.

In addition to determining the process to fabricate alumina nanofibers, our molecular level characterization of the materials has yielded a detailed understanding of the fibers' composition and structure. These studies have involved characterization of both the internal as well as the surface portion of the fibers. These studies allowed a determination of how fabrication procedures affect structure and composition of the alumina nanofibers. The characterizations have involved the application of solid-state nuclear magnetic resonance (SSNMR), Fourier transform infrared spectroscopy (FTIR), X-ray photoelectron spectroscopy (XPS), scanning and transmission electron microscopy (SEM and TEM, respectively), X-ray diffraction (XRD), secondary ion mass spectrometry (SIMS) and other characterization techniques. These studies allow one to determine fiber diameter and morphology, crystal structure and extent of crystallinity, surface elemental composition, surface active site structure and number, alumina phases present and a qualitative measure of surface area.

Fabrication procedure

*Electrospinning*

The application of electrospinning to form nanofibers of polyvinyl pyrrolidone/alumina-borate has been reported previously. These fibers were subsequently heated (calcined) to temperatures of 1000-1400°C to produce alumina-borate oxide fibers. While the procedure of electrospinning, followed by heating, has been used previously to form alumina, we have developed heating methods to fabricate nanofibers with unique structures, compositions and mechanical properties.

Fibers of polyvinyl pyrrolidone (PVP) containing aluminum acetate stabilized with boric acid (Al(ac)) with diameters of < 5 micrometer are produced by the method of electrospinning, see Figure 30. In this procedure an electrode at a negative potential is placed in a solution of PVP and Al(ac) that is contained in a pipette. In the vicinity of the pipette tip is a collector that is either grounded or held at a positive potential. The potential difference between the solution and collector results in the formation of jets of the polymer and aluminum reagent that are collected on the collector. The fibers generated by this technique form a non-woven mat on the collector surface. The diameter of the fibers is a function of temperature, humidity and the distance between the pipette tip and the collector.

(I) Aluminum Nanofibers

The polymers used in the electrospinning process can be, but are not limited to, those polymers (and related solvents) chosen from the following list:

| | Polymer | Solvent |
|---|---|---|
| 1 | Cellulose acetate | Acetone |
| 2 | Acrylic resin (96% acrylonitrile) | DMF |
| 3 | a) Polyethylene oxide | a) Water/chloroform |
| | b) Polyvinyl alcohol | b) Water |
| | c) Cellulose acetate | c) Acetone |
| 4 | a) Poly (2-hydroxy ethyl methacrylate) | a) Formic acid |
| | b) Polystyrene | |
| | c) Poly (ether amide) | |
| 5 | Polyethylene oxide (PEO) | |
| 6 | Polyethylene terephthalate | |
| 7 | Polyaniline/PEO blends | |
| 8 | Polyether urethane | |
| 9 | Poly-L-lactide (PLLA),<br>Polycarbonate (PC),<br>Polyvinylcarbazole | |
| 10 | Polystyrene | |
| 11 | Polybenzimidazole (PBI) | |
| 12 | Nylon 6 and Nylon 6 +montmorillonite (NLS) | |
| 13 | a) Polyethylene oxide (PE) | |
| | b) Polycarbonate (PC) | |
| | c) Polyurethane (PU) | |
| 14 | Polyvinyl chloride | |
| 15 | Polyurethane | |
| 16 | Polycaprolactone | |
| 17 | Styrene-Butadiene-Styrene (SBS) triblock copolymer | |
| 18 | Poly-L-Lactide | |
| 19 | Poly (methyl methacrylate-random) PMMA-r-TAN | |
| 20 | Polyethylene-co-vinyl acetate (PEVA), Poly lactic acid (PLA) and blend of PEVA and PLA. | |
| 21 | Poly (p-phenylene terephthalamide) (PPTA) (Kevlar 49 from Dupont) | |
| 22 | Polyethylene terephthalate (PET) and Polyethylene naphthalate (PEN) | |
| 23 | Silk like polymer with fibronectin functionality (SLPF) | |
| 24 | Polyurethane and PEO Dimethylformamide | |

b) Dimethyl Formamide and Diethyl Formamide

c) Hexafluoro 2- propanol Water

(continued)

Mixture of dichloromethane and trifluoroacetic acid
Chloroform
Dimethyl acetamide
Dichloromethane
Tetrahydrofuran (THF)
N,N-Dimethyl Acetamide (DMAc) 1,1,1,3,3,3-hexafluoro-2-Propanol (HFIP) and DMF
a) Isopropyl alcohol (IPA)
b) DMF and THF
c) DMF
THF, DMF
DMF
Acetone
75% THF and 25% DMF
Dichloromethane
Mixed solvent of Toluene and DMF
Chloroform
95-98 wt % Sulphuric acid
Formic acid/hexafluoro isopropanol
Tetrahydrofuran and

The aluminum reagent can be, but is not limited to, either charged or neutral aluminum compounds. Examples of aluminum reagents include aluminum acetate, aluminum acetate stabilized with boric acid, aluminum alkoxides (methoxide, ethoxide, butoxide, propoxide, etc.). Additional non-aluminum embodiments will yield various other metal oxides and include but are not limited to titanium, silica, nickel, magnesium, alkyl titanate, and finally tin/nickel combinations which yield PN junctions.

The solvent may be, but is not limited to, water, ethanol and/or methanol. The solvent may also include the presence of an acid (carbonic, formic, acetic, soluble carboxylic acids).

The optimal ambient humidity during electrospinning is less than 50% relative humidity.

<u>Thermal treatment of Metal-Oxide Nanofibers:</u>

The fibers generated using electrospinning are subsequently thermally treated to remove all, or a portion of the polymer and to convert the aluminum reagent into alumina. The temperatures during the thermal treatment are 500˚C to 1200˚C for times from 10 minutes to 6 hours. In this text the term alumina refers to material consisting primarily of aluminum, oxygen and hydrogen, with the aluminum primarily occupying 4, 5, or 6-coordinate sites within the material. The fibers may also contain other elements originating from the solution from which the fibers are electrospun or from the thermal treatment process. The fibers generated after sample heating are < 5 micrometer in diameter, see Figure 31. The elemental distribution within the fibers may not be heterogeneous, as the boron present in some alumina fibers is present at higher levels at the fiber surface, see Figure 32.

The thermal treatment of the fibers is done in either an oven that is open to ambient atmosphere, i.e. the "wet-bake" method, or in an oven that is closed to the atmosphere, i.e. the "dry-bake" method. In the case of the wet-bake method, the oven contains an opening (chimney) that allows for the circulation of ambient atmosphere through the oven during the heating process, whereas in the dry-bake method the oven does not contain an opening. The humidity level during the thermal treatment process can be varied by adding additional water to the oven.

In the wet-bake method the alumina fibers generated are similar to the $\gamma$-alumina phase when the samples are heated to 525˚C and in the $\alpha$-alumina phase when heated to 1200˚C. Samples heated at intermediate temperatures have structures similar to the $\eta$, $\delta$, and $\theta$phases. At all temperatures below 1200˚C the fibers may consist of a mixture of alumina phases. The phases present in the alumina nanofibers are identified by Al solid-state NMR (Figure 33) and X-ray diffraction techniques (Figure 34). After heating to 1200˚C, the fibers have low tensile strength and are brittle. The fraction of 4, 5 and 6-coordinate alumina sites in the nanofibers are different from those reported for bulk alumina heated to similar temperatures. The different coordination sites of aluminum are determined form Al SSNMR where the Al chemical shift for 6-coordinate sites is 0-20 ppm, 5-coordinate sites is 35-60 ppm and the 4-coordinate sites is 65-80 ppm.

The material generated after heating electrospun nanofibers is very different from the material generated by simply heating Al(ac). When Al(ac) is heated, the Al solid-state NMR data shows that the resulting material is dominated

by 4- and 5-coordinate aluminum sites, see Figure 38. Whereas when the PVP/Al(ac) as-spun fibers are heated, the material has a very different distribution of alumina sites. The formation of the fiber yields a different form of alumina.

In the dry-bake method the distribution of the 4, 5 and 6-coordinate alumina sites in the nanofibers is different than that observed in the fibers fabricated using the wet-bake method. The alumina phases present in the fibers are identified by Al solid-state NMR (Figure 34) and X-ray diffraction techniques (Figure 35). The alumina nanofibers produced by the dry-bake method have a lower extent of crystallinity and are more flexible than those produced by the wet-bake method. The alumina fibers produced by the dry-bake method can be modified to be closer in structure to those of the wet-bake method by adding known quantities of water to the oven, along with the electrospun fibers, before beginning the thermal treatment process. The surface structure of the wet-bake and dry-bake alumina nanofibers are different from each other, as determined from Al SSNMR and Fourier transfer infrared (FTIR) spectroscopy, and different from alumina formed by traditional methods, see Figures 36 and 37.

During the heating of the polymer/alumina reagent nanofiber samples to generate alumina fibers the material curls at the edges of the samples. In order to keep the fiber mat flat it can be placed between two pieces of aluminum during sample heating. The decomposition products of the polymer and aluminum reagent need to escape and water needs to reach the nanofibers during heating. Access to the nanofibers is achieved either by channels along the length of the aluminum blocks or channels that pass entirely through the block normal to the surface containing the nanofibers. Schematics of the heating apparati are shown in Figure 38.

## Aluminum Nanofibers

The structure and composition of alumina fibers is dependent on the annealing process used to form the fibers. In addition, the structure and composition of the surface of the fibers is dependent on the annealing/thermal treatment process used to make the fibers.

The composition and structure of the alumina fibers is different from the material generated by annealing the alumina reagent in the absence of the polymer nanofiber.

Annealing/thermally treating as-spun fibers with limited exposure to ambient atmosphere produces alumina fibers with increased flexibility.

Heating electrospun fibers in the presence of ambient atmosphere to 525˚C produces nanofibers of alumina that are similar to, but different from gamma-alumina. Heating electrospun fibers in the presence of ambient atmosphere to 1200˚C produces nanofibers of alumina that are similar to, but different from alpha-alumina. Heating electrospun fibers in the presence of ambient atmosphere between 525˚C and 1200˚C produces nanofibers of alumina that contain structures similar to one or more of the $\gamma$,$\eta$, $\delta$, $\theta$ and $\alpha$-phases of alumina. Heating electrospun fibers in an oven with limited intake of ambient atmosphere produces alumina nanofibers with different distributions of 4, 5 and 6-coordinate alumina sites than observed for heating in ambient atmosphere.

Addition of water to the oven during the time of nanofiber sample heating changes the distribution of 4, 5 and 6-coordinate alumina sites in the alumina nanofibers.

The surface structure of alumina nanofibers is different from bulk alumina and the structure can be controlled by annealing temperatures, time and atmosphere.

## Utilization of Dual Nanofiber Structures

The metal oxide nanofibers produced by the current invention are subject to various embodiments regarding choice and/or structure. In one embodiment two different metal oxide nanofibers are woven together in a helical fashion like yarn. In another embodiment, 3 different, 4 different or even 5 different nanofibers are used to create a nanofiber with varying applicational uses. For example, the properties of one metal oxide nanofiber may be best used to combat reagent A while another nanofiber may be best used to combat reagent Y. The combination of both in a yarn or spun together by another means offers the user the best properties of both nanofibers. The utilization of multiple nanofibers is not limited to spinning together or twisting together. The nanofibers may be attached end to end to for lengths with alternating properties. Again the alternating properties allowing for a wider range of applicability for the fibers.

## Fabrication of Alumina Nanofibers Containing Lithium Salts for Use as Separator/Electrolyte Materials in Lithium-Ion Batteries

A lithium-ion batteries consist of three main parts: anode, electrolyteseparator and cathode, see Figure 40. The reactions within the battery during discharge include:

Anode: carbon/Li$\rightarrow$ $Li^+$ + $e^-$
Separator/electrolyte: $Li^+$ conduction from anode to cathode

Cathode: $LiCoO_2$ or $LiMn_2O_4 + Li^+ + e^-$

During the recharging process of the battery, these reactions occur in reverse.

The separator/electrolyte serves two roles; (1) conduct Li ions between the two electrodes and, (2) prevent the electrodes from coming into contact. Typical electrolyte/separator materials for lithium-ion batteries possess the following properties: a high ionic conductivity, a high chemical stability, a stability to potentials in excess of four volts, the ability to retain high ionic conductivity over a wide temperature range, and are inexpensive to produce while being environmentally friendly. Commercially available lithium-ion batteries have one of three basic designs for the electrolyte; (1) an organic solvent, typically carbonates, with a LiX (X = the anion) salt, (2) a polymer, typically polyethylene oxide, with a LiX salt and (3) a polymer with the presence of some organic solvent, with a LiX salt. There are, however, a number of problems with these configurations. Systems that contain organic solvents must be packaged so there is no leakage or evaporation of the solvent. In the case of the polymer systems, they suffer from low ionic conductivities. In addition, the presence of the organic solvent leads to potential fires with lithium-ion batteries. One method which overcomes these drawbacks is the use of solid, inorganic, glass and ceramic electrolytes. Examples include lithium oxides, lithium phosphates, lithium oxynitrides (LIPON), lithium sufides and oxysulfides as well as a large number of other systems.

Alumina nanofibers, produced using the electrospinning process and containing a lithium salt have optimum properties as separator/electrolytes. These materials benefit from having relatively high ionic conductivity (>0.17mS/cm), being chemically and electrochemically stable, lightweight, inexpensive to produce, and environmentally friendly. Nanofibers with diameters less than one micron have a high surface area, providing for a large contact area with the electrodes at a low mass of nanofibers. The alumina nanofibers are fabricated such that they are flexible, providing for a separator/electrolyte material used in flexible lithium-ion batteries. This flexibility helps reduce disconnection between the alumina nanofibers and the electrodes during flexing of the battery or changes in electrode size during battery discharge and recharging. The nanofiber fabrication parameters are controlled to generate materials with varying percentage crystallinity, defect site density, composition and structure of the alumina allowing for optimization of the fiber morphology, composition and structure to achieve maximum ionic conductivity. The fibers are fabricated and then applied to the electrodes in battery production or the fibers can be electrospun directly onto the electrode surface.

In order for the nanofibers to be effective as a lithium cation conducting material in, they must contain a lithium salt. The incorporation of the lithium salts on, or into, the alumina nanofibers can be accomplished using various embodiments, three of which are detailed below:

In one embodiment the alumina nanofibers are produced by electrospinning a solution that contains a polymer, such as, but not limited to, polyvinylpyrrolidinone (PVP), and an alumina reagent, such as, but not limited to, aluminum acetate stabilized with boric acid. This is followed by annealing the nanofibers at temperatures between 200 and 1200˚C to form nanofibers of alumina. Optionally added to the solution is a lithium salt, followed by electrospinning the solution to generate polymer nanofibers containing the alumina and lithium reagents. The fibers are then annealed to generate alumina-lithium salt nanofibers, see Figure 41.

In another embodiment the electrospun nanofibers of PVP and an alumina reagent, either before or after annealing, are immersed in a solution of a lithium salt. This coats and/or impregnates the fibers with the lithium salt and then the fibers can be used as is or annealed at elevated temperatures.

In still another embodiment the electrospun nanofibers of PVP and an alumina reagent, either before or after annealing, are exposed to the vapors of a lithium salt by use of chemical vapor deposition, sputtering or laser ablation. The fibers are then used as is or annealed at elevated temperatures.

Although the invention has been described in detail with particular reference to certain embodiments detailed herein, other embodiments can achieve the same results. Variations and modifications of the present invention will be obvious to those skilled in the art and the present invention is intended to cover in the appended claims all such modifications and equivalents.

1. A method of producing a metal oxide nanofiber having improved catalytic, conductive, surface or structural functionality comprising the steps of:

(I) selecting and providing a least one metal oxide precursor and at least one polymer to at least one nanofiber producing device;
(II) mixing the at least one metal oxide precursor, the at least one polymer and optionally a solvent;
(III) electrospinning the resultant mixture to produce fibers containing the at least one metal oxide precursor and the at least one polymer;
(IV) thermally treating the fibers to create the metal oxide nanofiber having improved functionalities; and
(V) collecting the metal oxide nanofiber.

2. The method of 1 wherein the at least metal oxide precursor is selected from aluminum acetate, aluminum acetate stabilized with boric acid, aluminum alkoxide, alkyl titanate, tetraisopropyl titanate and/or a combination thereof.

3. The method of 1 wherein the at least one polymer is selected from Cellulose acetate, Acrylic resin, Polyethylene oxide, Polyvinyl alcohol, Cellulose acetate, Poly (2-hydroxy ethyl methacrylate), Polystyrene, Poly (ether amide), Polyethylene oxide (PEO), Polyethylene terephthalate, Polyaniline/PEO blends, Polyether urethane, Poly-L-lactide (PLLA), Polycarbonate (PC), Polyvinylcarbazole, Polystyrene, Polybenzimidazole (PBI), Nylon 6 and Nylon 6 +montmorillonite (NLS), Polyethylene oxide (PE), Polycarbonate (PC), Polyurethane (PU), Polyvinyl chloride, Polyurethane, Polycaprolactone, Styrene-Butadiene-Styrene, (SBS) triblock copolymer, Poly-L-Lactide, Poly (methyl methacrylate-random), PMMA-r-TAN, Polyethylene-co-vinyl acetate (PEVA), Poly lactic acid (PLA) and blend of PEVA and PLA, Poly (p-phenylene terephthalamide), (PPTA) (Kevlar 49 from Dupont), Polyethylene terephthalate (PET), Polyethylene naphthalate (PEN), Silk like polymer with fibronectin functionality (SLPF), Polyurethane PEO, polyvinylypyrrolidone and/or a combination thereof.

4. The method of 1 wherein the solvent is water, ethanol, methanol, carbonic acid, formic acid, acetic acid soluble carboxylic acid, and/or a combination thereof.

5. The method of 1 wherein the thermal treatment includes calcining the metal oxide precursor and pyrrolyzing the polymer by heating the fibers to between about 500˚C and about 1200˚C for a time from about 10 minutes to about 6 hours.

6. The method of 1 wherein the thermal treatment occurs under a specified atmosphere.

7. The method of 1 wherein the thermal treatment occurs by controlling the exposure to the ambient atmosphere.

8. The method of 1 wherein the thermal treatment partially removes the polymer.

9. The method of 1 wherein the at least one metal oxide precursor is aluminum acetate, aluminum acetate stabilized with boric acid, or aluminum alkoxide; and
the electrospun fibers are heated in the presence of an ambient atmosphere to about 525˚C to produce an alumina nanofiber other than gamma-alumina or are heated to about 1200˚C to produce an alumina nanofiber other than alpha-alumina.

10. The method of 1 wherein the at least one metal oxide precursor is aluminum acetate, aluminum acetate stabilized with boric acid, or aluminum alkoxide; and
the electrospun fibers are heated in the presence of an ambient atmosphere from about 500˚C to about 1200˚C to produce a nanofiber similar to one or more of $\gamma$,$\eta$, $\delta$, $\theta$ and $\alpha$-phases of alumina.

11. The method of 1 wherein the electrospinning includes introducing an electrical means to charge the solution and the collecting of the metal oxide nanofiber utilizes a grounded device or a device charged with an opposite polarity from the fiber.

12. The method of 1 wherein the collecting of the metal oxide nanofiber includes the use of a segmented rotating drum and sets of equally spaced wires grounded to create potential differences with respect to a spinnerette tip utilized in electrospinning for collecting one or more non-woven electrospun nanofibers in a continuous sheet.

13. The method of 12 wherein the one or more metal oxide nanofibers have oriented alignments.

14. The method of 12 wherein the one or more metal oxide nanofibers have a combination of fibers with oriented alignments and random alignments.

15. The method of 12 wherein the one or more metal oxide nanofibers form a mat.

16. The method of 1 further comprising selecting, providing and combining metal oxide nanoparticles with the polymer and metal oxide precursor prior to thermal treatment.

17. The method of 16 wherein the nanoparticles are magnesia, erbia, alumina, a metal, an oxide and/or combinations thereof

18. The method of 1 further comprising depositing and controlling the properties of the at least one metal oxide nanofiber coating using vapor deposition techniques prior to thermal treatment.

19. The method of 18 wherein the vapor deposition techniques include chemical vapor deposition, sputtering or laser ablation.

20. The method of 1 further comprising depositing and controlling the properties of the at least one metal oxide nanofiber coating using vapor deposition techniques after thermal treatment.

21. The method of 20 wherein the vapor deposition techniques include chemical vapor deposition, sputtering or laser ablation.

22. A method of producing a metal oxide nanofiber having improved catalytic, conductive, surface or structural functionality comprising the steps of:

(a) selecting and providing one or more polymer nanofibers;
(b) coating the one or more polymer nanofibers with sol-gel precursors;
(c) thermally treating the one or more polymer nanofibers and sol-gel mix to transform the resultant sheet into metal oxides;
(d) incorporating the polymer nanofibers into compatible micro-sized fiber filter media via vacuum molding; and
(e) optionally using an acrylic binder to hold the metal oxide nanofibers together.

23. A method of producing a metal oxide nanofiber having improved catalytic, conductive, surface or structural functionality comprising the steps of:

(i) selecting and providing one or more polymer nanofibers;
(ii) coating the one or more polymer nanofibers with sol-gel precursors;
(iii) incorporating the polymer nanofibers into compatible micro-sized fiber filter media via vacuum molding;
(iv) thermally treating the one or more polymer nanofibers and sol-gel mix to transform the resultant sheet into metal oxides; and
(v) optionally using an acrylic binder to hold the metal oxide nanofibers together.

24. A method of producing a composite metal oxide nanofiber and polymer nanofiber having improved catalytic, conductive, surface or structural functionality comprising the steps of:

(A) selecting and providing a least one metal oxide precursor and/or metal oxide nanoparticles to at least one nanofiber producing device;
(B) selecting and providing a least one polymer to the at least one nanofiber producing device;
(C) mixing the at least one metal oxide precursor and/or metal oxide nanoparticles, the at least one polymer and optionally a solvent;
(D) electrospinning the resultant mixture to produce fibers containing the at least one metal oxide precursor and/or metal oxide nanoparticles and the at least one polymer;
(E) thermally treating the fibers to create the composite metal oxide nanofiber and polymer nanofiber having improved functionalities; and
(F) collecting the composite metal oxide nanofiber and polymer nanofiber.

25. The method of 24 wherein the nanoparticles are magnesia, alumina and /or erbia.

26. A metal oxide nanofiber as produced by the process of 1.

27. A metal oxide nanofiber as produced by the process of 22.

28. A metal oxide nanofiber as produced by the process of 23.

29. A metal oxide nanofiber as produced by the process of 24.

30. An electrospun, metal oxide nanofiber having improved catalytic, conductive, surface or structural functionality comprising:

one or more metal oxides precursors;
one or more polymers; and
the one or more metal oxide precursors and one or more polymers selected so as to be compatible with one another.

31. The electrospun, metal oxide nanofiber of 30 wherein the metal oxide precursor is aluminum acetate, aluminum acetate stabilized with boric acid, aluminum alkoxide, alkyl titanate, or tetraisopropyl titanate.

32. The electrospun, metal oxide nanofiber of 30 wherein the polymer is Cellulose acetate, Acrylic resin, Polyethylene oxide, Polyvinyl alcohol, Cellulose acetate, Poly (2-hydroxy ethyl methacrylate), Polystyrene, Poly (ether amide), Polyethylene oxide (PEO), Polyethylene terephthalate, Polyaniline/PEO blends, Polyether urethane, Poly-L-lactide (PLLA), Polycarbonate (PC), Polyvinylcarbazole, Polystyrene, Polybenzimidazole (PBI), Nylon 6 and Nylon 6 +montmorillonite (NLS), Polyethylene oxide (PE), Polycarbonate (PC), Polyurethane (PU), Polyvinyl chloride, Polyurethane, Polycaprolactone, Styrene-Butadiene-Styrene, (SBS) triblock copolymer, Poly-L-Lactide, Poly (methyl methacrylate-random), PMMA-r-TAN, Polyethylene-co-vinyl acetate (PEVA), Poly lactic acid (PLA) and blend of PEVA and PLA, Poly (p-phenylene terephthalamide), (PPTA) (Kevlar 49 from Dupont), Polyethylene terephthalate (PET), Polyethylene naphthalate (PEN), Silk like polymer with fibronectin functionality (SLPF), Polyurethane, PEO or polyvinylypyrrolidone.

33. The electrospun metal oxide nanofiber of 30 wherein the one or more polymers is coated with one or more metal oxides nanoparticles.

34. The electrospun metal oxide nanofiber of 30 wherein the one or more polymers forms a composite with one or more metal oxides nanoparticles.

35. The electrospun metal oxide nanofiber of 30 wherein the one or more polymers is coated with one or more metals.

36. The electrospun metal oxide nanofiber of 30 wherein the one or more polymers forms a composite with one or more metal particles.

37. The electrospun metal oxide nanofiber of 30 wherein the one or more polymers and one or more metal oxides form a composite.

38. The electrospun metal oxide nanofiber of 30 wherein the one or more metal oxides are nanoparticles of magnesia and/or alumina.

39. The electrospun metal oxide nanofiber of 30 arranged into a mat comprising randomly oriented nanofibers.

40. The electrospun metal oxide nanofiber of 30 arranged into a mat comprising oriented nanofibers.

41. The electrospun metal oxide nanofiber of 30 arranged into a mat comprising a combination of fibers with oriented alignments and random alignments.

42. The electrospun metal oxide nanofiber of 30 further comprising nano-scale particles of magnesia and/or alumina incorporated into titania nanofibers.

43. The electrospun metal oxide nanofiber of 30 combined with one or more additional nanofibers to form a multi-component nanofiber composite.

44. The multi component nanofiber composite of 43 wherein the additional nanofibers are metal oxide nanofibers.

45. The multi component nanofiber composite of 43 wherein the electrospun metal oxide nanofibers are twisted together.

46. The multi component nanofiber composite of 43 wherein the electrospun metal oxide nanofibers are arranged as a grid with P/N junctions.

47. A device for protecting against chemical exposure comprising one or more metal oxide nanofibers.

48. The device of 47 wherein the chemical exposure is via a phosphorus and/or sulfur-based nerve agent.

49. The device of 47 wherein the one or more metal oxide nanofibers is woven into a fabric.

50. The device of 47 wherein the one or more metal oxide nanofibers is incorporated into a polymer sheet.

51. The device of 47 wherein the one or more metal oxide nanofibers is used in a respiratory filter.

52. The device of 47 wherein the one or more nanofibers are combined with fibers larger than the one or more nanofibers.

53. The device of 47 wherein the one or more nanofibers are combined with additional materials to form a composite which allows the passage of moisture.

54. An electrolyte for use in lithium ion batteries comprising an alumina-lithium salt nanofiber made from lithium salt incorporated into or onto alumina nanofibers.

55. The alumina lithium salt nanofiber of 54 made by the process of:

electrospinning a solution of a polymer, a lithium salt and an alumina reagent; and
thermally treating the resultant nanofibers at a temperature between 200 and 1200˚C.

56. The alumina lithium salt nanofiber of 54 made by the process of:

electrospinning a solution of a polymer and an alumina reagent into one or more nanofibers;
immersing the resultant nanofibers in a solution of lithium salt; and
thermally treating the resultant nanofibers at a temperature between 200 and 1200˚C.

57. The alumina lithium salt nanofiber of 54 made by the process of:

electrospinning a solution of a polymer and an alumina reagent into one or more nanofibers;
thermally treating the resultant nanofibers at a temperature between 200 and 1200˚C; and
immersing the resultant nanofibers in a solution of lithium salt.

58. The alumina lithium salt nanofiber of 54 made by the process of:

electrospinning a solution of a polymer and an alumina reagent into one or more nanofibers;
immersing the resultant nanofiber into solution of lithium salt.; and
thermally treating the resultant nanofiber at a temperature between 200 and 1200˚C.

59. The alumina lithium salt nanofiber of 54 made by the process of:

electrospinning a solution of a polymer, and an alumina reagent;
thermally treating the resultant nanofibers at a temperature between 200 and 1200˚C; and
exposing the resulting nanofiber to the vapors of lithium salts.

60. The alumina lithium salt nanofiber of 59 wherein the vapors of lithium salts are produced via chemical vapor deposition, sputtering or laser ablation.

61. The alumina lithium salt nanofiber of 54 made by the process of:

electrospinning a solution of a polymer, and an alumina reagent;
exposing the resulting nanofiber to the vapors of lithium salts; and
annealing the resultant nanofibers at a temperature between 200 and 1200˚C.

62. The alumina lithium salt nanofiber of 61 wherein the vapors of lithium salts are produced via chemical vapor deposition, sputtering or laser ablation.

## Claims

1. A method of producing a metal oxide nanofiber having improved catalytic, conductive, surface or structural functionality comprising the steps of:

   (a) selecting and providing one or more polymer nanofibers;
   (b) coating the one or more polymer nanofibers with sol-gel precursors;
   (c) thermally treating the one or more polymer nanofibers and sol-gel mix to transform the resultant sheet into metal oxides;
   (d) incorporating the polymer nanofibers into compatible micro- sized fiber filter media via vacuum molding; and
   (e) optionally using an acrylic binder to hold the metal oxide nanofibers together,
   wherein the order of steps (c) and (d) can be interchanged.

2. The method of claim 1, wherein the method comprises the steps of:

   (A) selecting and providing at least one metal oxide precursor and/or metal oxide nanoparticles to at least one nanofiber producing device;
   (B) selecting and providing at least one polymer to the at least one nanofiber producing device;
   (C) mixing the at least one metal oxide precursor and/or metal oxide nanoparticles, the at least one polymer and optionally a solvent;
   (D) electrospinning the resultant mixture to produce fibers containing the at least one metal oxide precursor and/or metal oxide nanoparticles and the at least one polymer;
   (E) thermally treating the fibers to create the composite metal oxide nanofiber and polymer nanofiber having improved functionalities; and
   (F) collecting the composite metal oxide nanofiber and polymer nanofiber.

3. The method of claim 2, wherein the nanoparticles are magnesia, alumina and/or erbia.

4. A metal oxide nanofiber as produced by the process of any of claims 1 to 3.

5. The metal oxide fiber of claim 4, wherein the metal oxide fiber is an electrospun metal oxide nanofiber and wherein the one or more polymers is coated with one or more metal oxides nanoparticles or one or more metal particles.

6. The electrospun metal oxide nanofiber of claim 5, wherein the one or more polymers forms a composite with one or more metal oxides nanoparticles or the one or more metal particles.

7. The electrospun metal oxide nanofiber of any of claims 4 to 6, wherein the electrospun metal oxide nanofiber is combined with one or more additional nanofibers to form a multi-component nanofiber composite.

8. The multi-component nanofiber composite of claim 7, wherein the electrospun metal oxide nanofibers are twisted together or wherein the electrospun metal oxide nanofibers are arranged as a grid with P/N junctions.

9. A device for protecting against chemical exposure comprising one or more metal oxide nanofibers of any of claims 4 to 8.

10. An electrolyte for use in lithium ion batteries comprising an alumina-lithium salt nanofibers made from lithium salt incorporated into or onto alumina nanofibers.

11. The alumina lithium salt nanofiber of claim 10, made by the process of:

    electrospinning a solution of a polymer, a lithium salt and an alumina reagent; and
    thermally treating the resultant nanofibers at a temperature between 200˚C and 1200˚C.

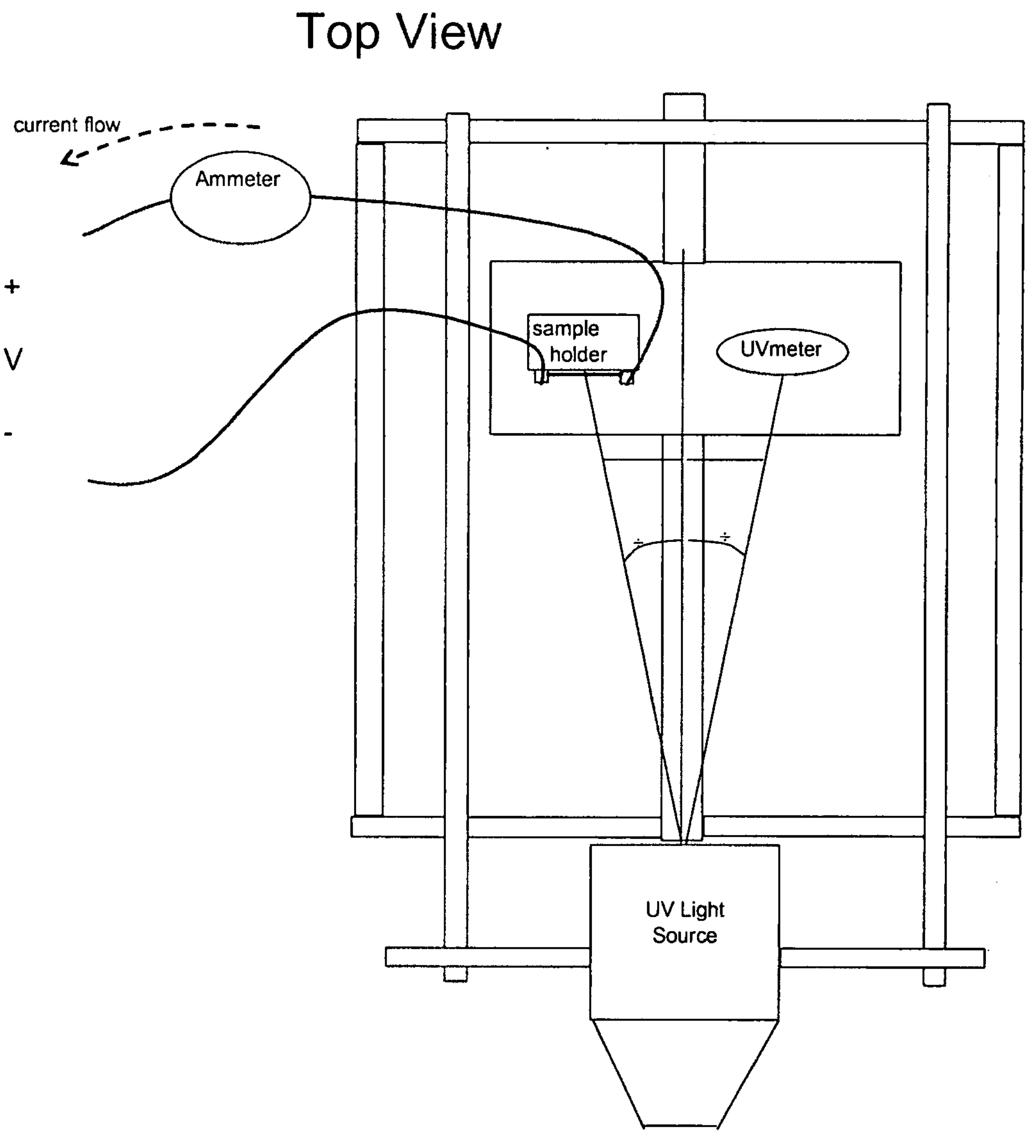
Top View
current flow
Ammeter
+
V
-
sample holder
UVmeter
UV Light Source

**Figure 1**

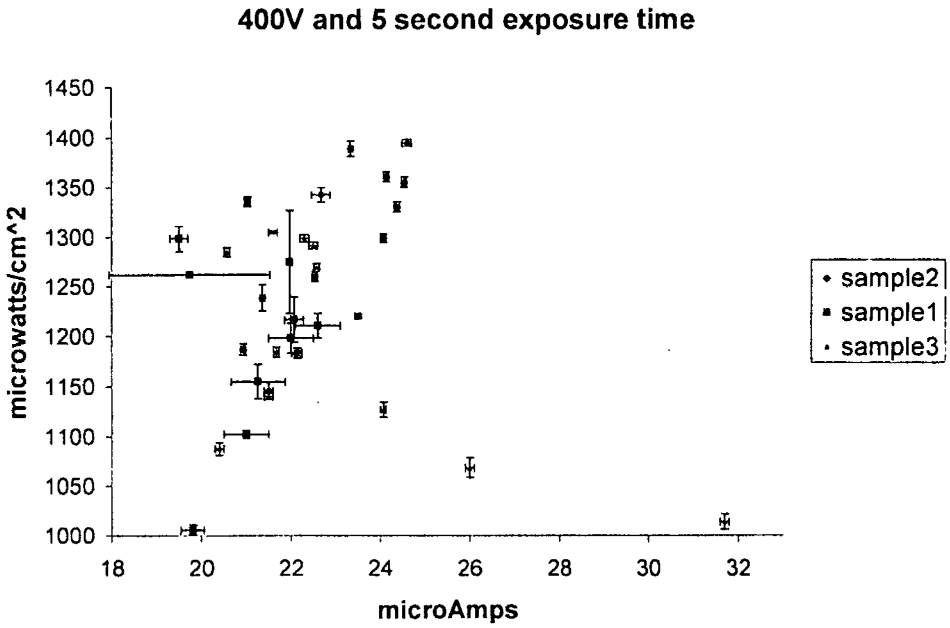


Figure 2

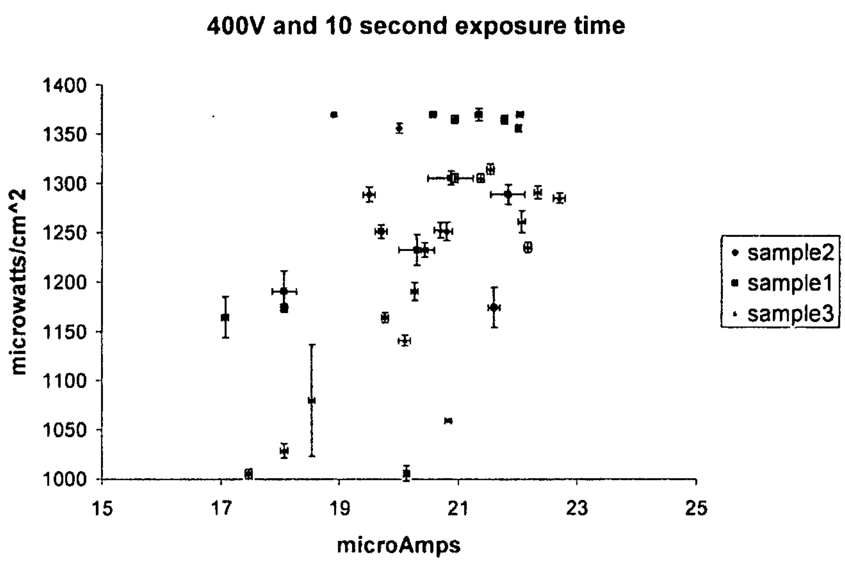


Figure 3

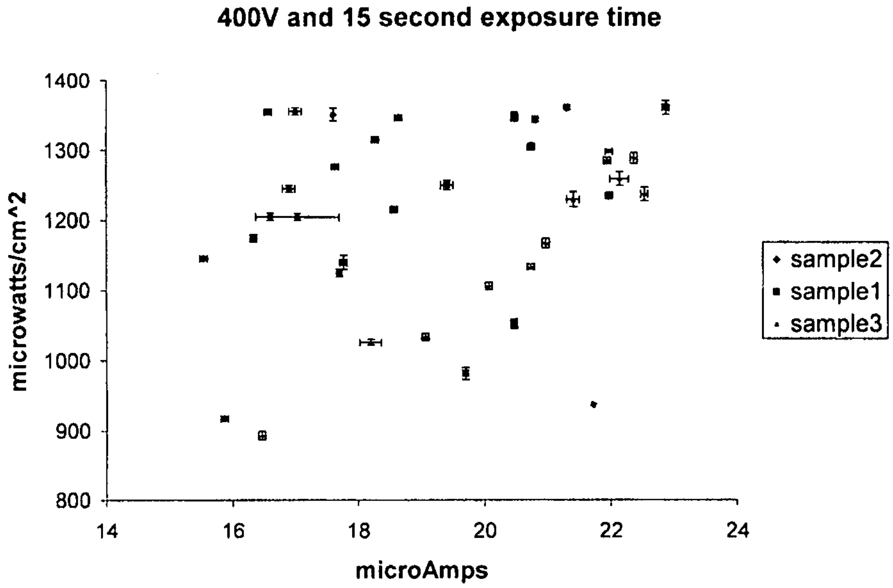


Figure 4

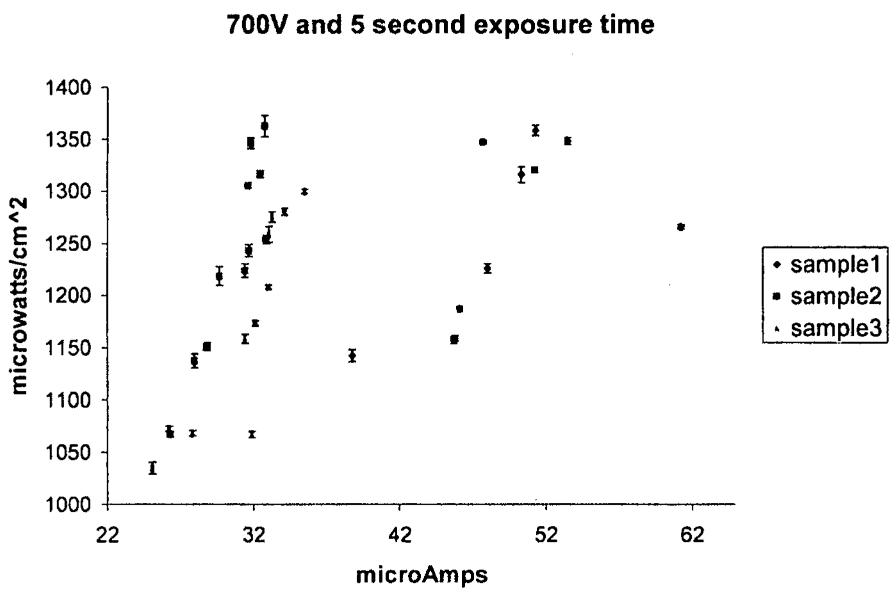


Figure 5

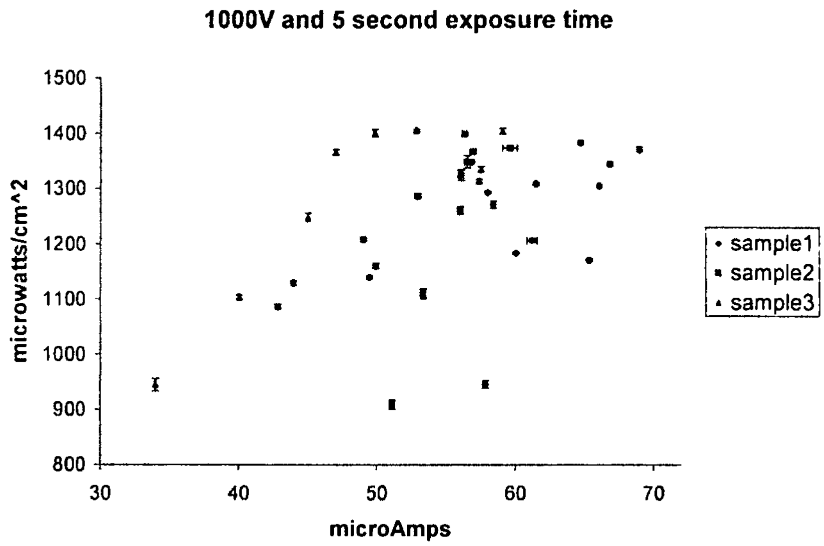


Figure 6

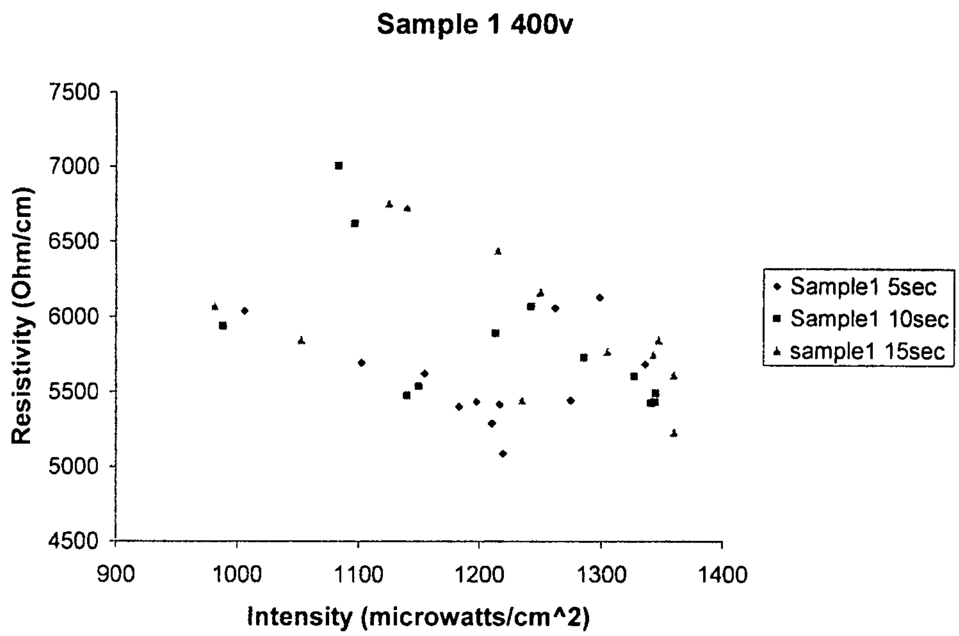


Figure 7

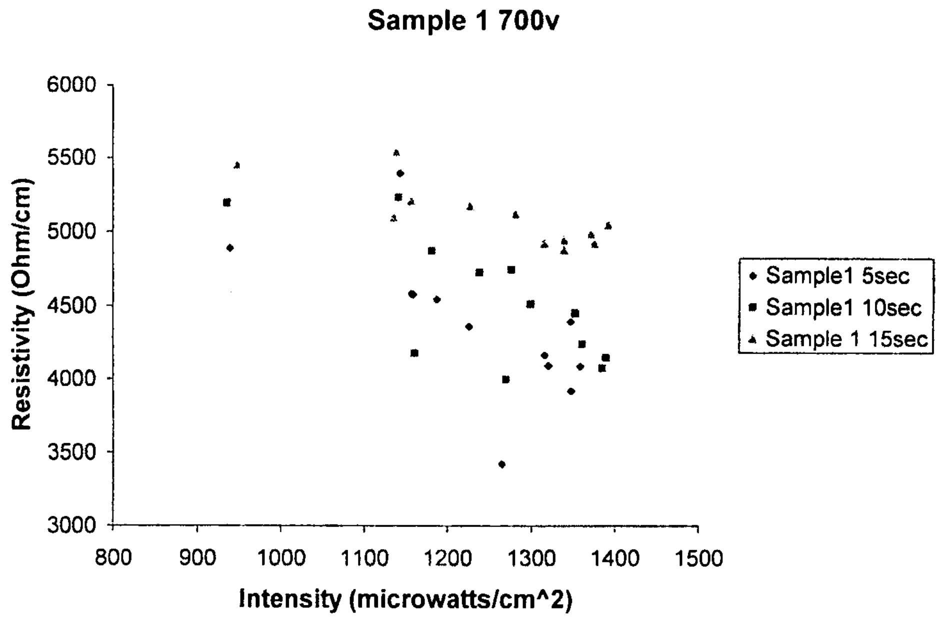


Figure 8

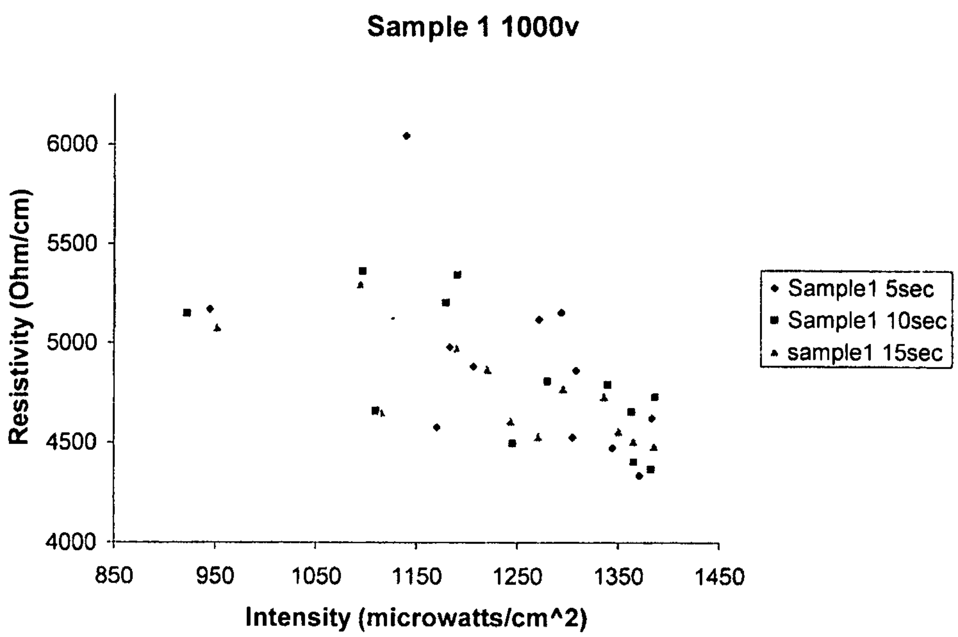


Figure 9

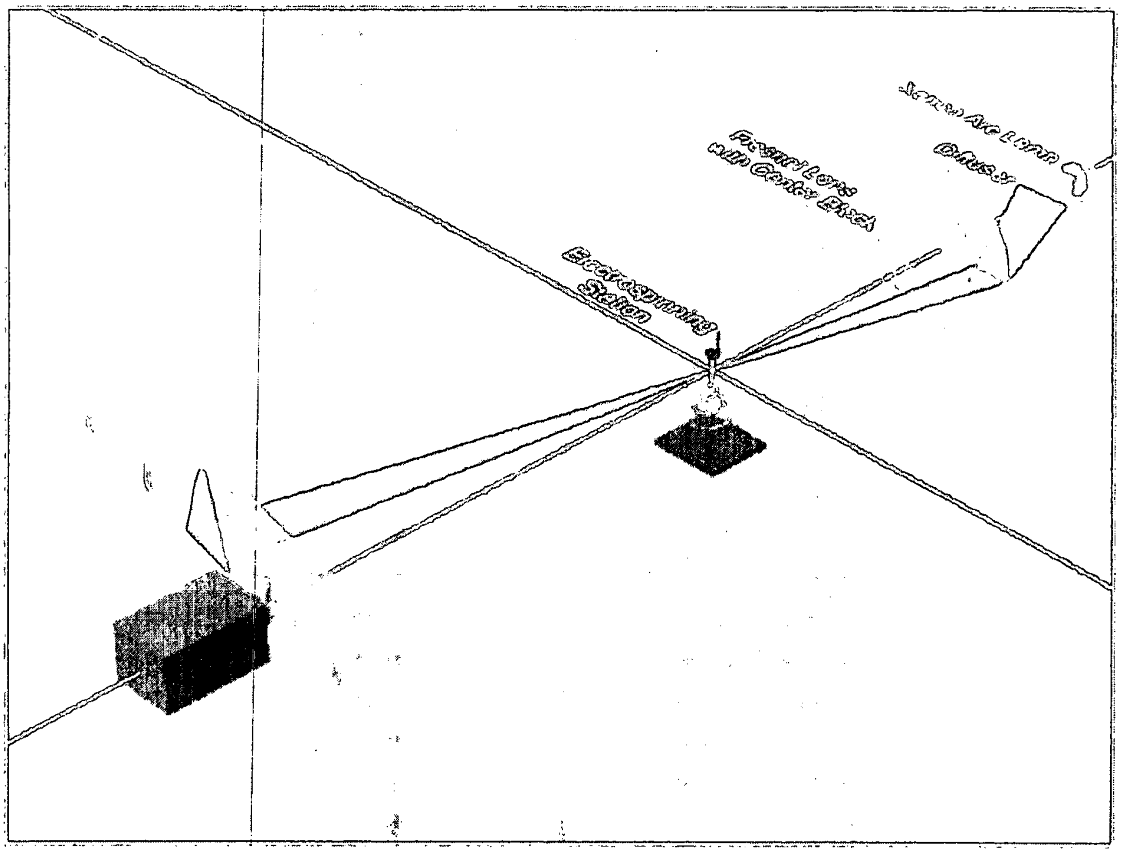


Figure 10

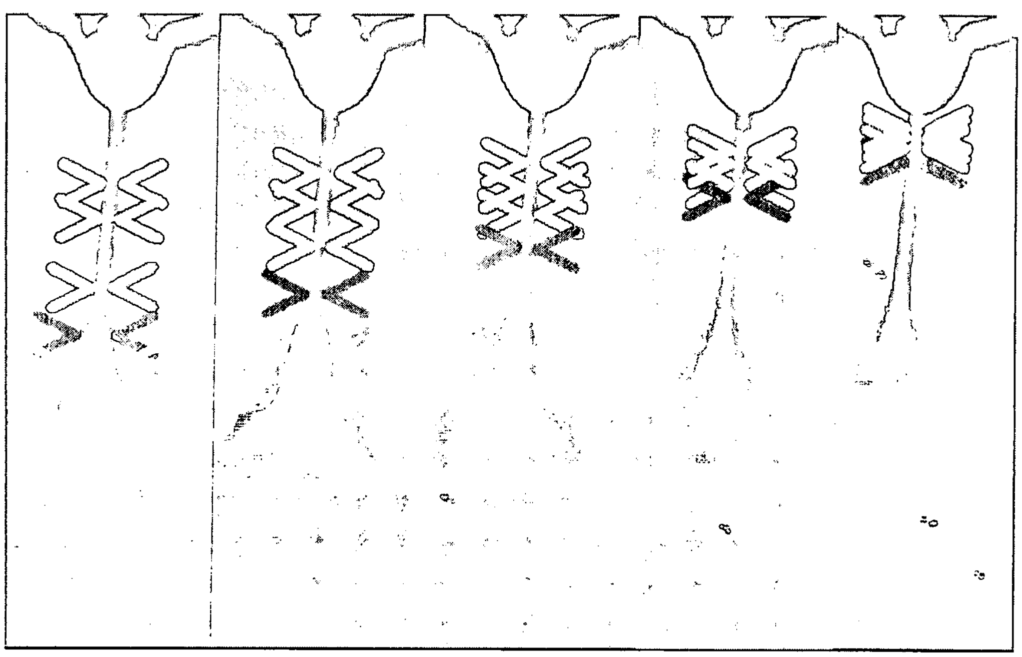

Figure 11

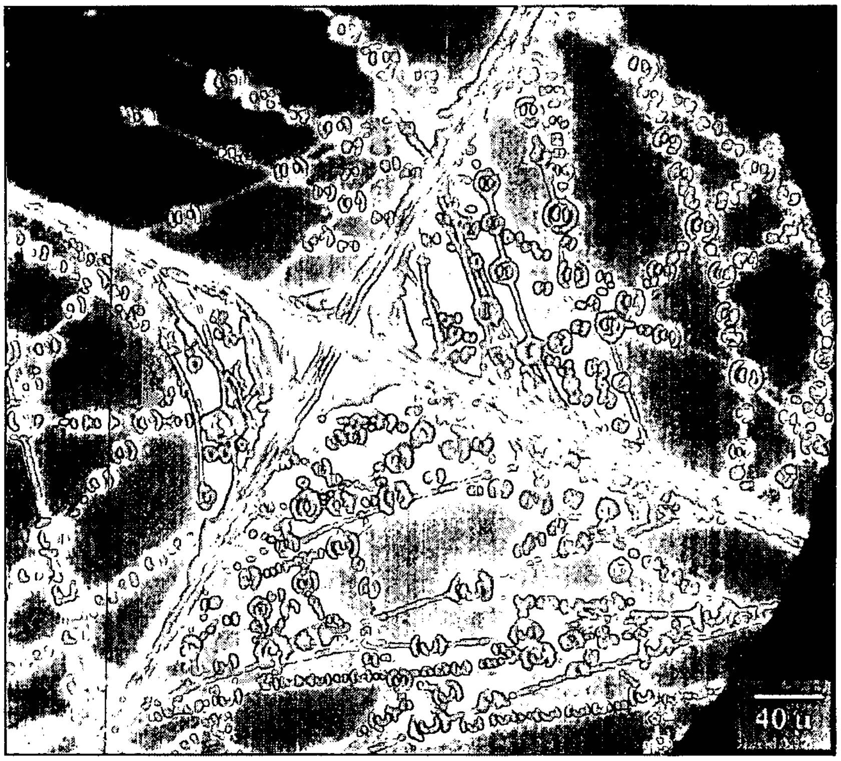


Figure 12

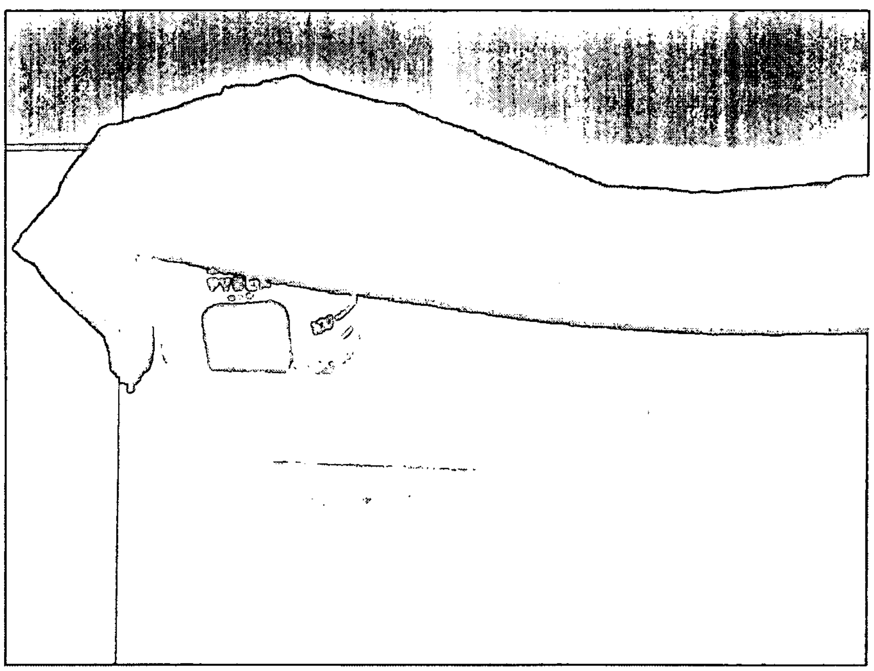

Figure 13

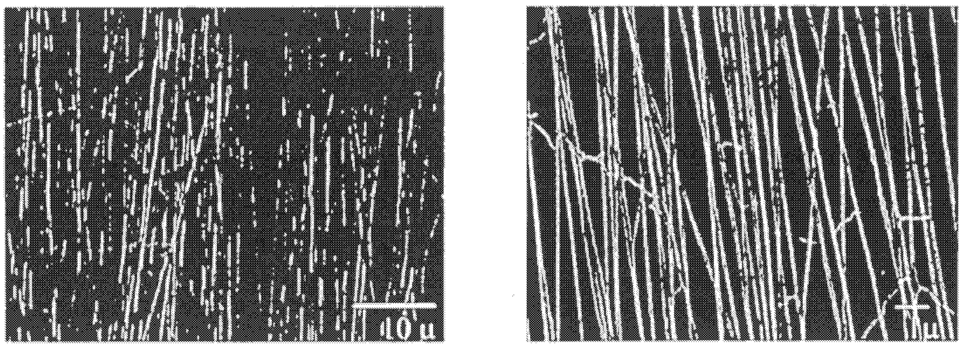


Figure 14

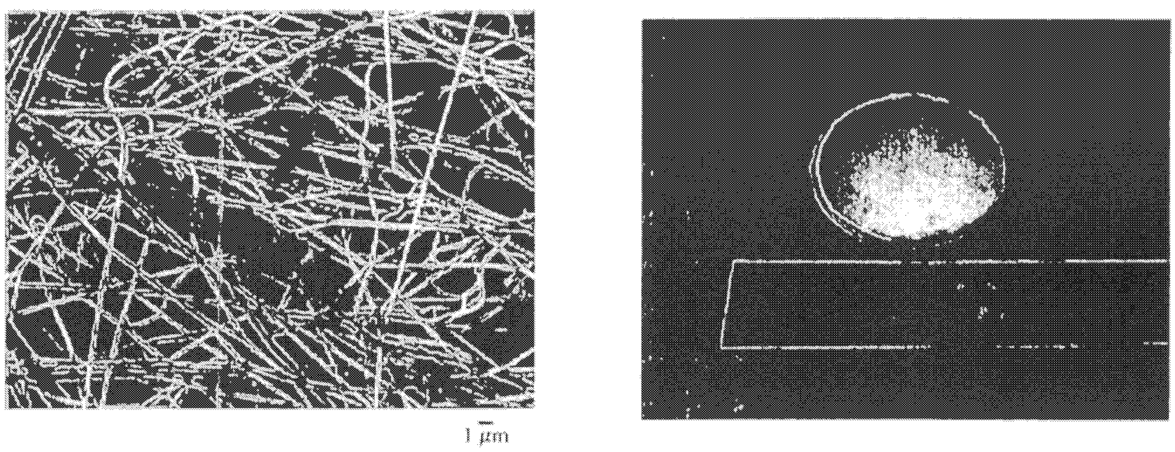


Figure 15

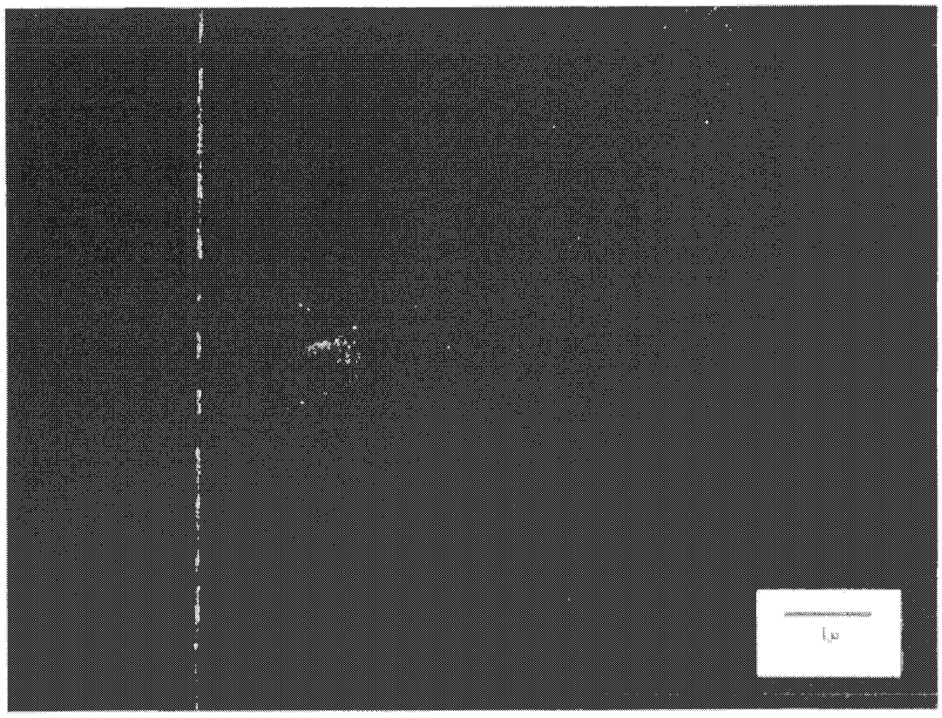


Figure 16

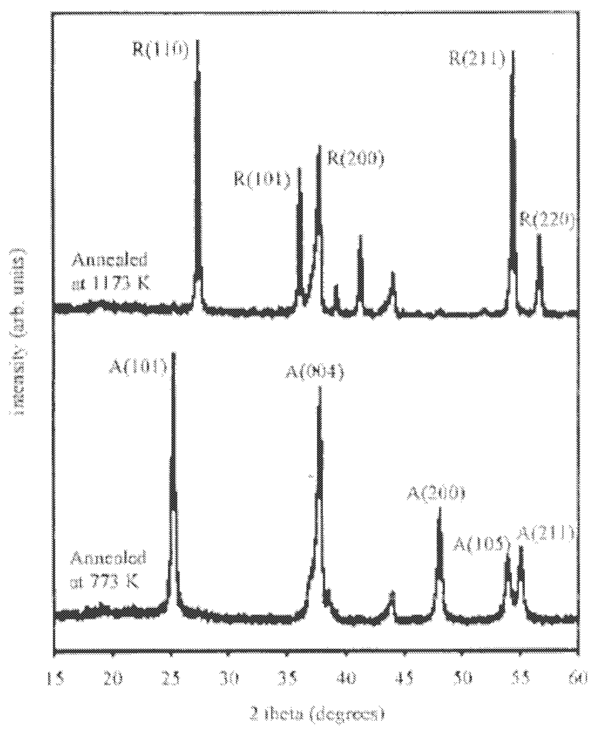


Figure 17

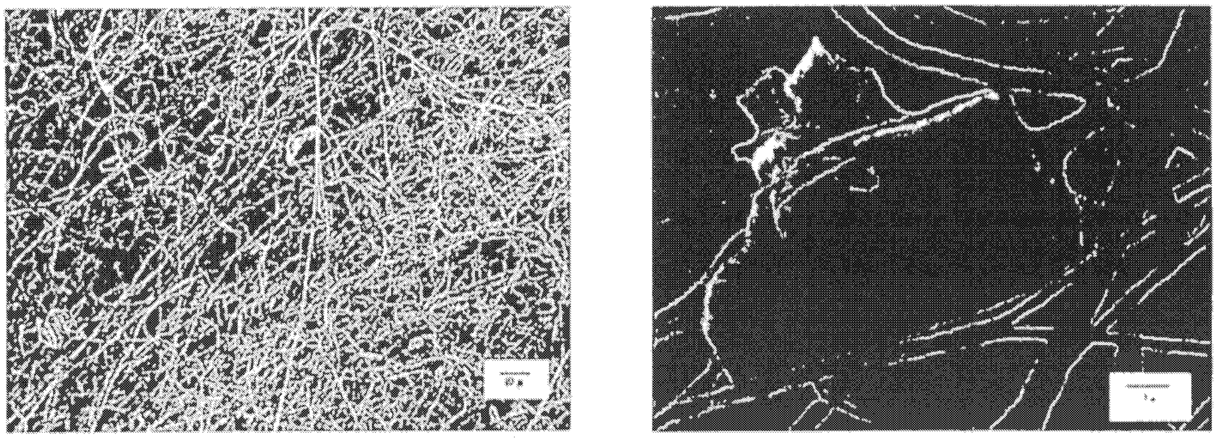

Figure 18

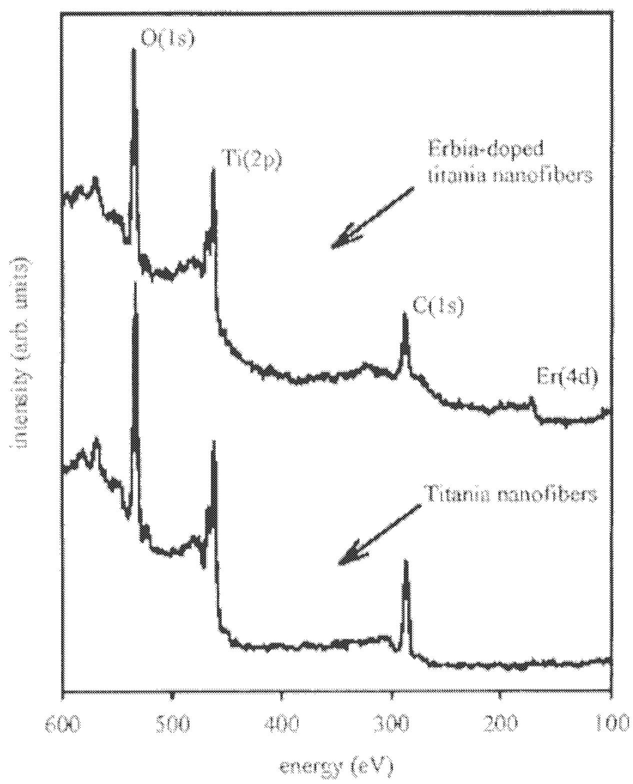


Figure 19

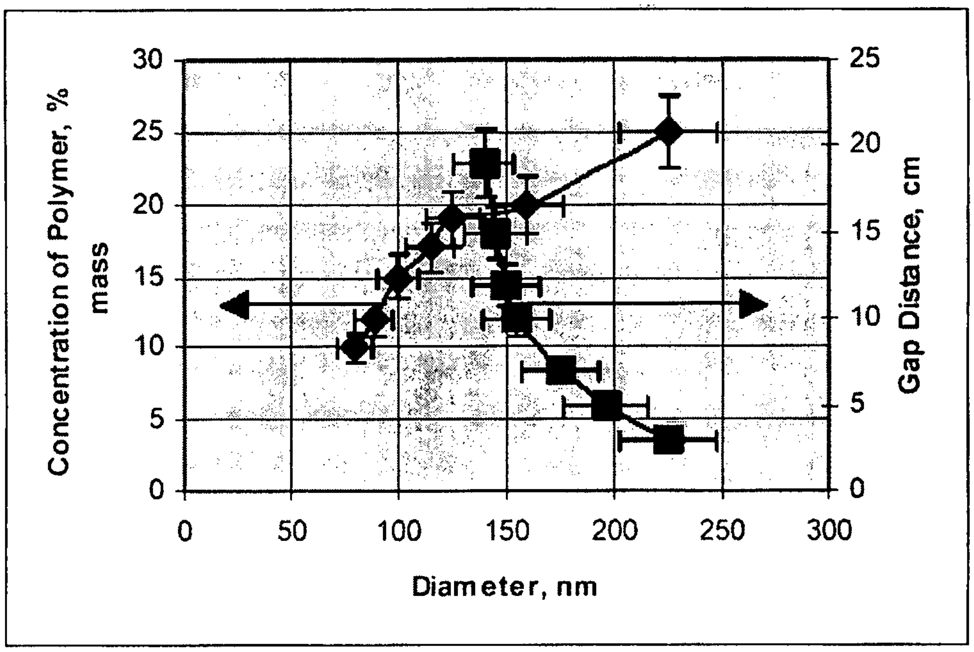


Figure 20

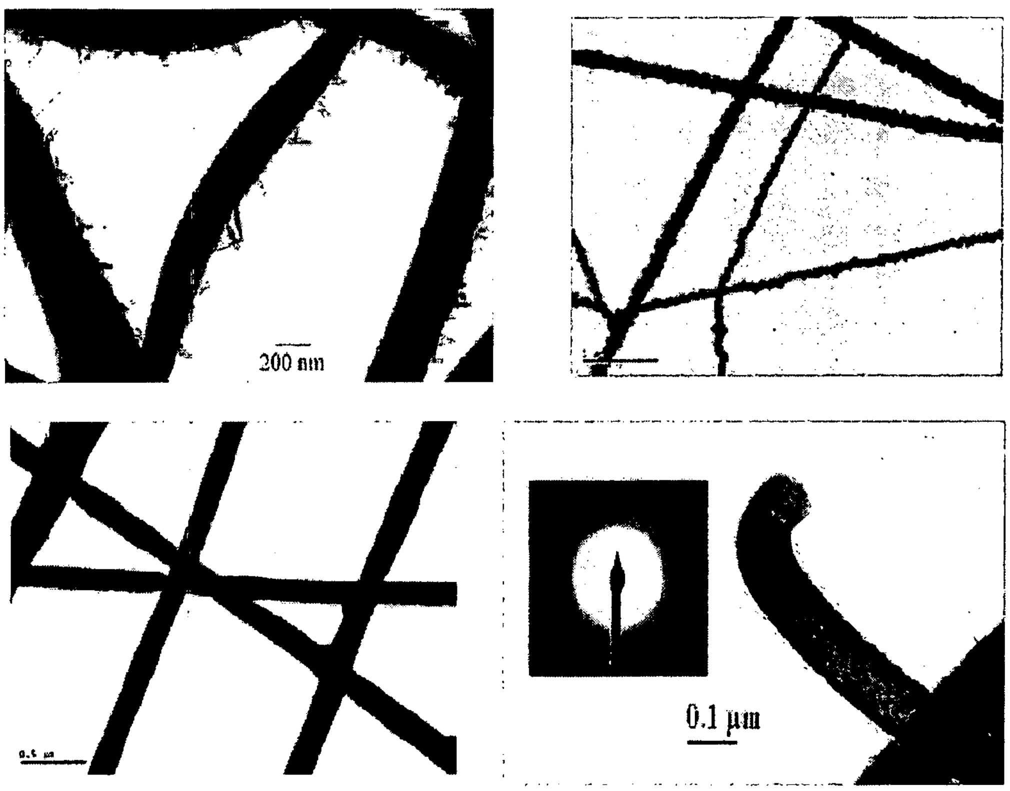


Figure 21

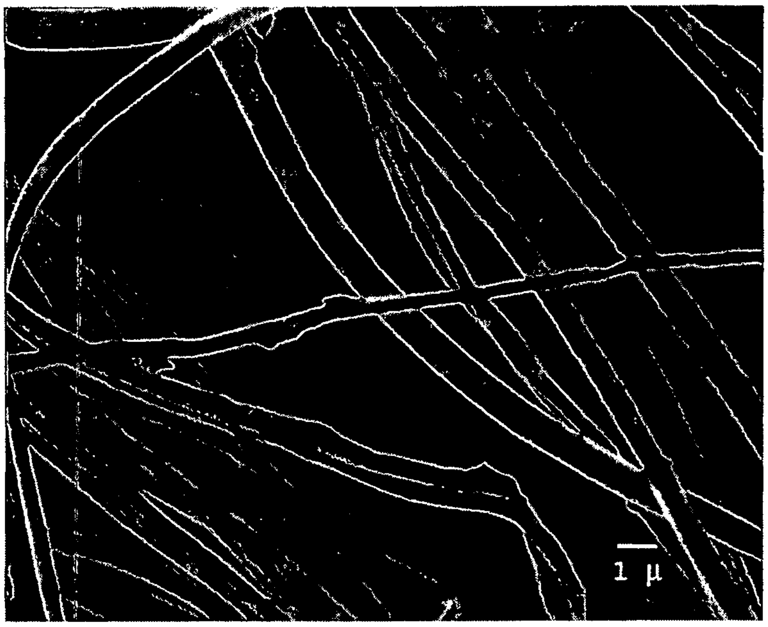


Figure 22

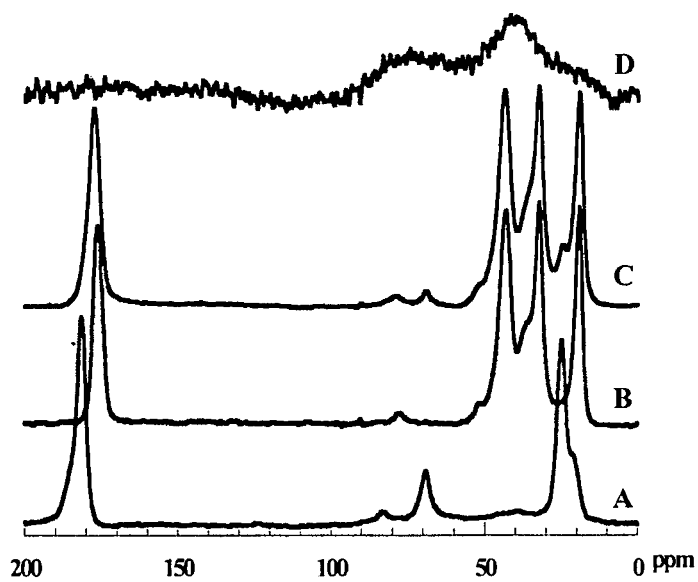


Figure 23

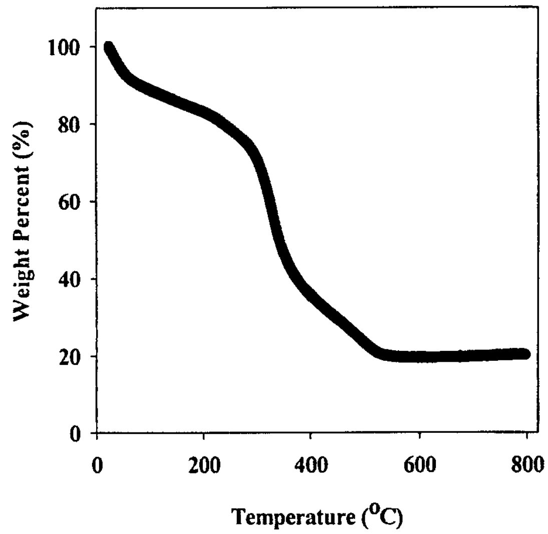


Figure 24

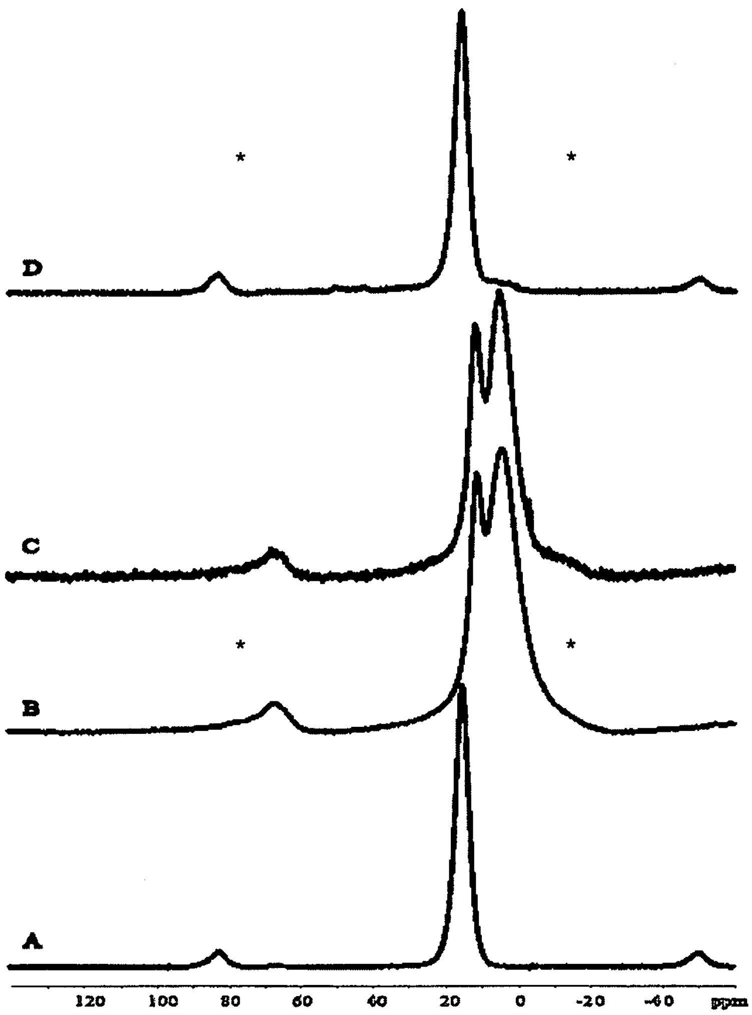


Figure 25

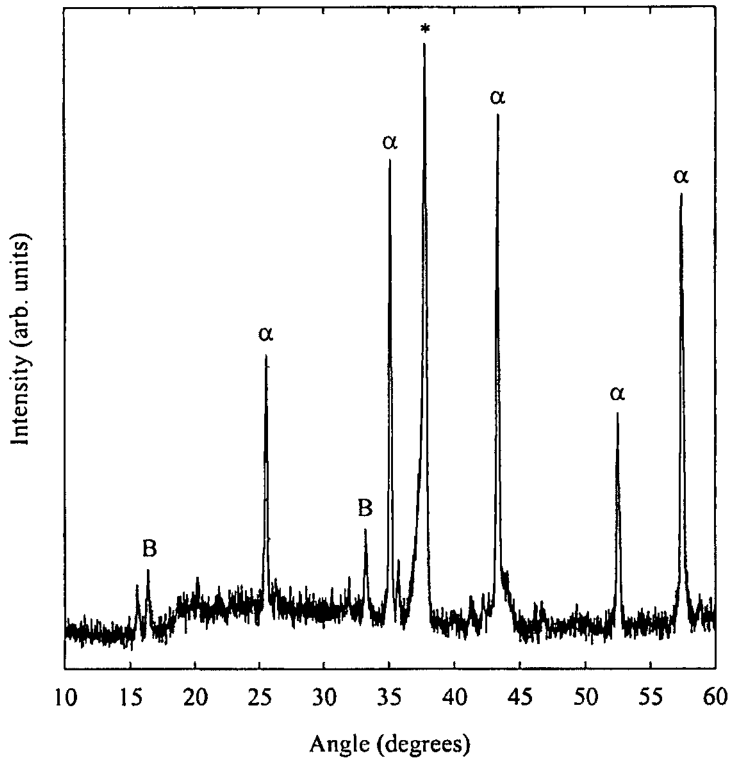


**Figure 26**

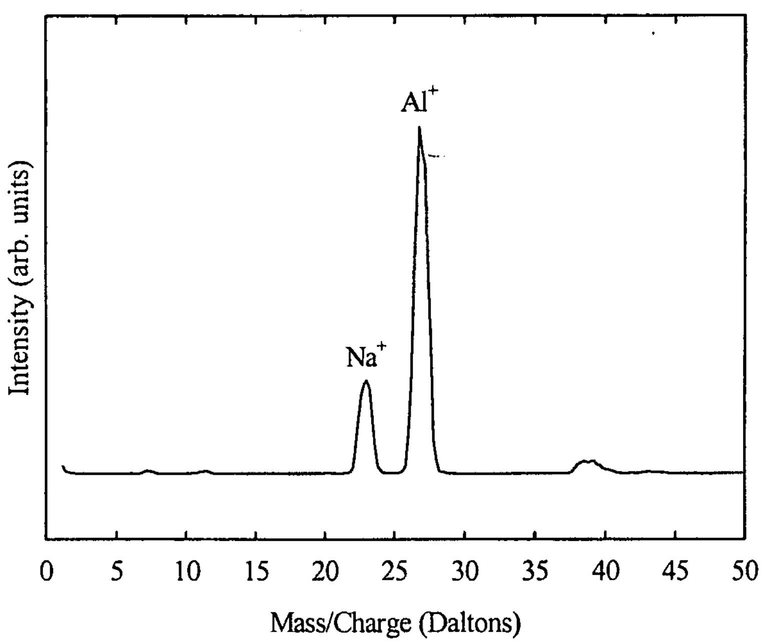


**Figure 27**

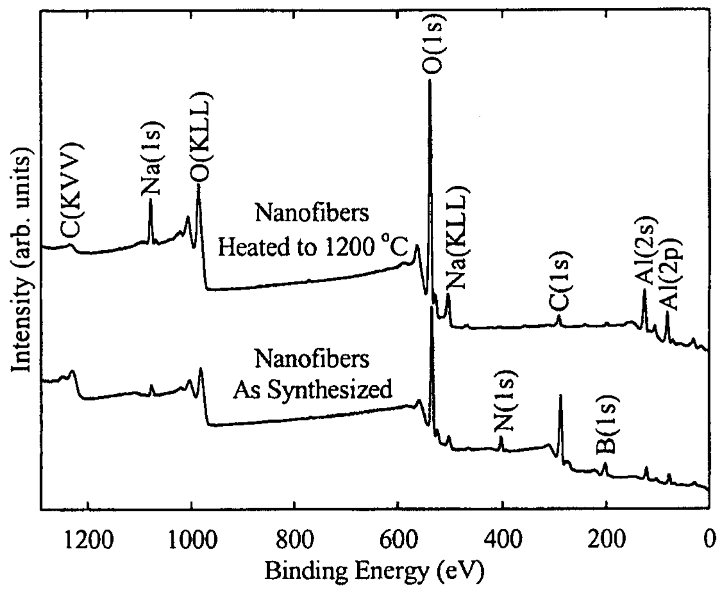


**Figure 28**

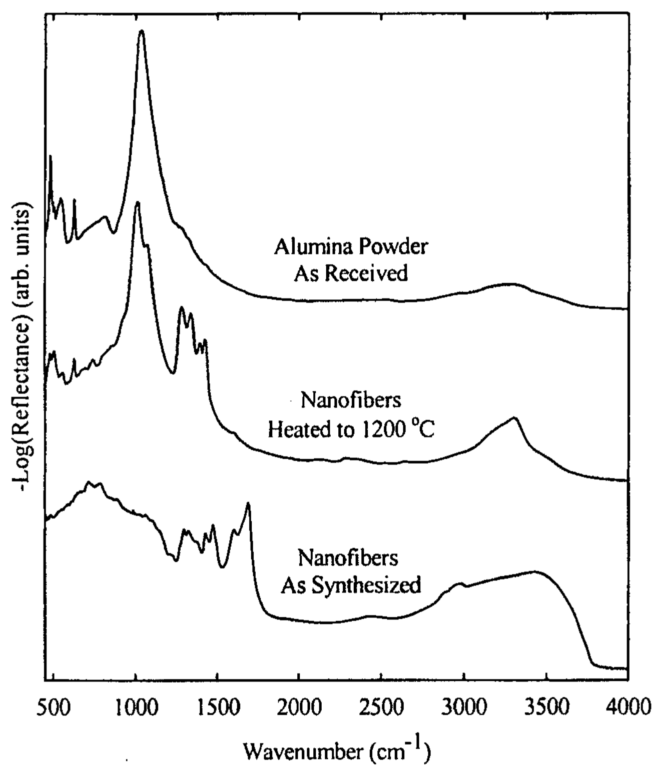


**Figure 29**

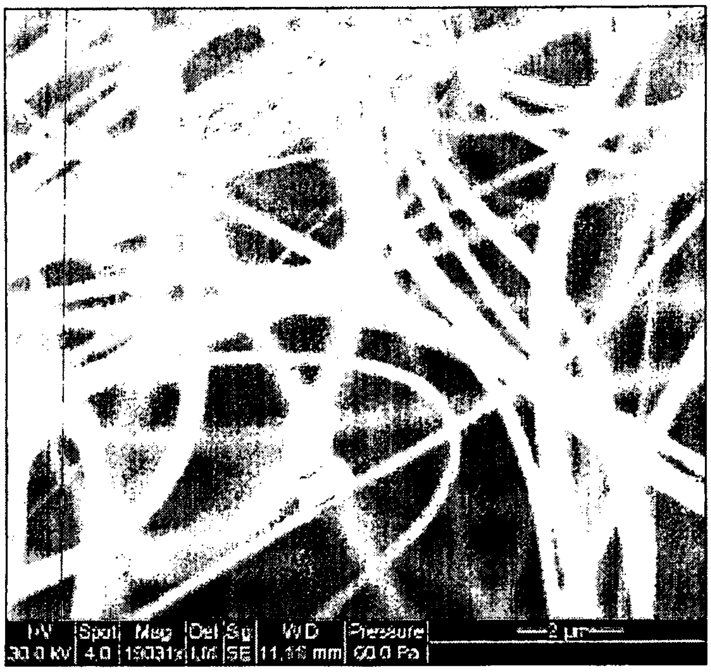


Figure 30

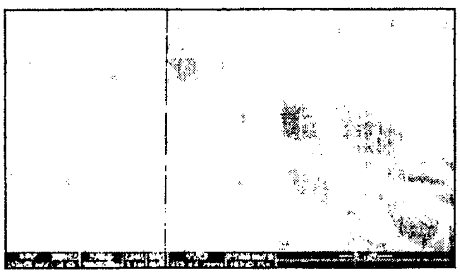

525C

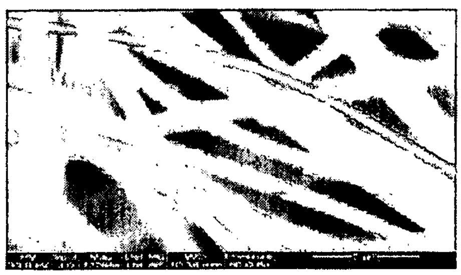

800C

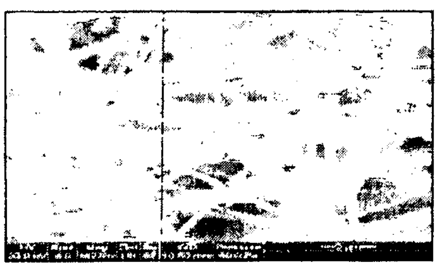

1000C

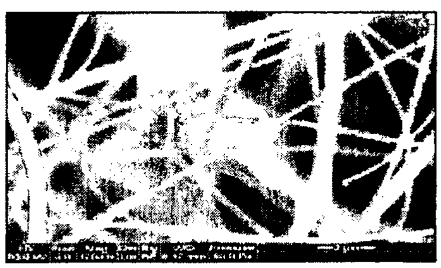

1200C

Figure 31

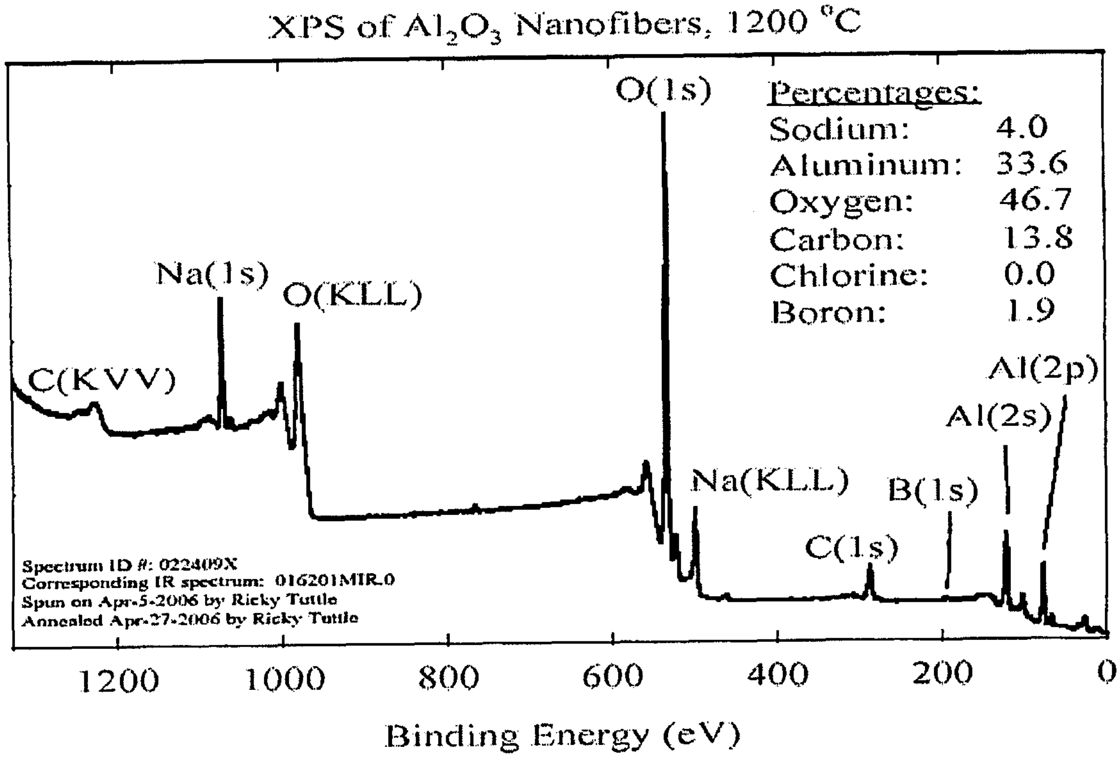
XPS of $Al_2O_3$ Nanofibers, 1200 °C
O(1s)
Percentages:
Sodium: 4.0
Aluminum: 33.6
Oxygen: 46.7
Carbon: 13.8
Chlorine: 0.0
Boron: 1.9
Na(1s)
O(KLL)
C(KVV)
Al(2p)
Al(2s)
Na(KLL)
B(1s)
C(1s)
Spectrum ID #: 022409X
Corresponding IR spectrum: 016201MIR.0
Spun on Apr-5-2006 by Ricky Tuttle
Annealed Apr-27-2006 by Ricky Tuttle
1200
1000
800
600
400
200
0
Binding Energy (eV)

Figure 32

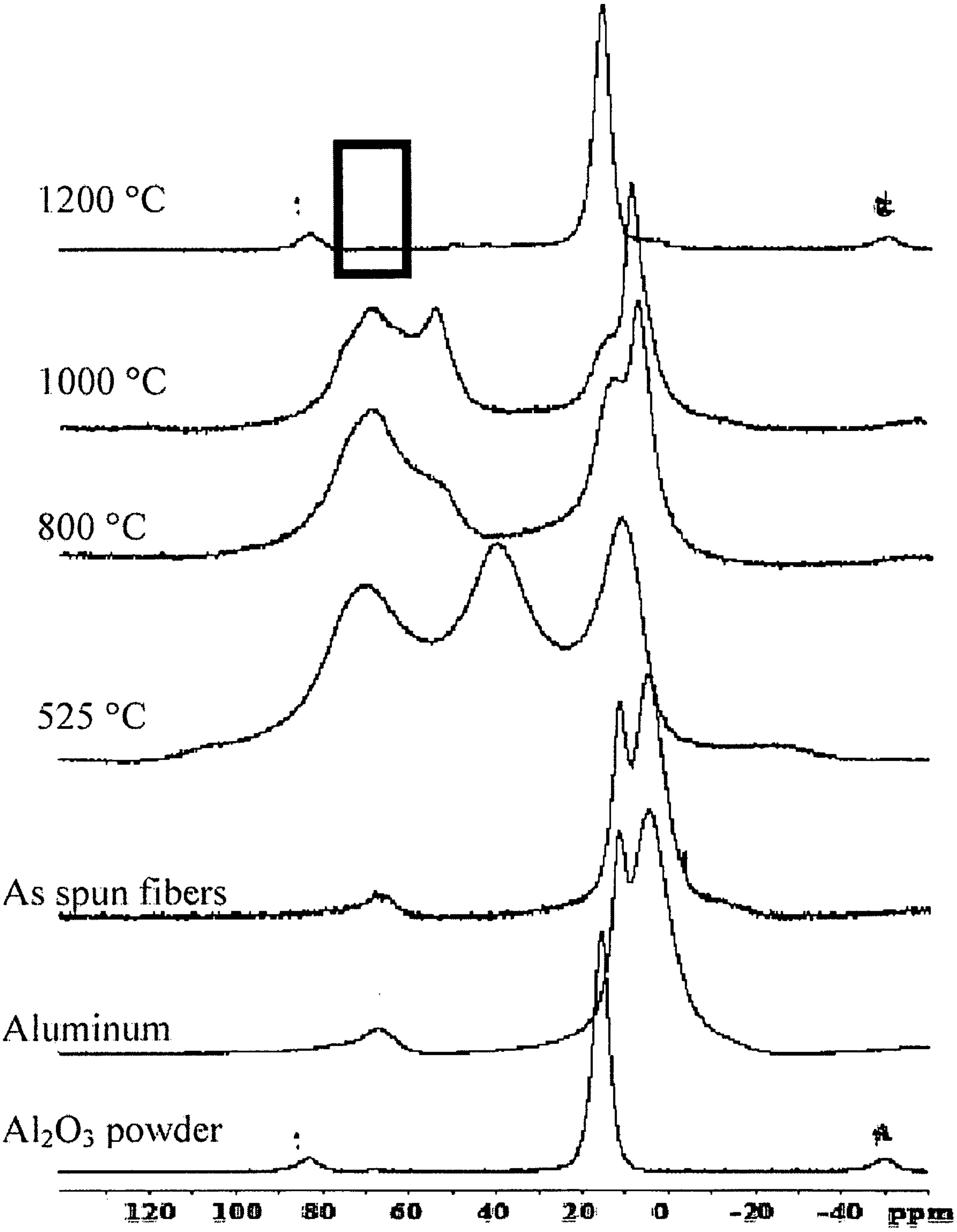

1200 °C
1000 °C
800 °C
525 °C
As spun fibers
Aluminum
$Al_2O_3$ powder
120
100
80
60
40
20
0
-20
-40
ppm


Figure 33

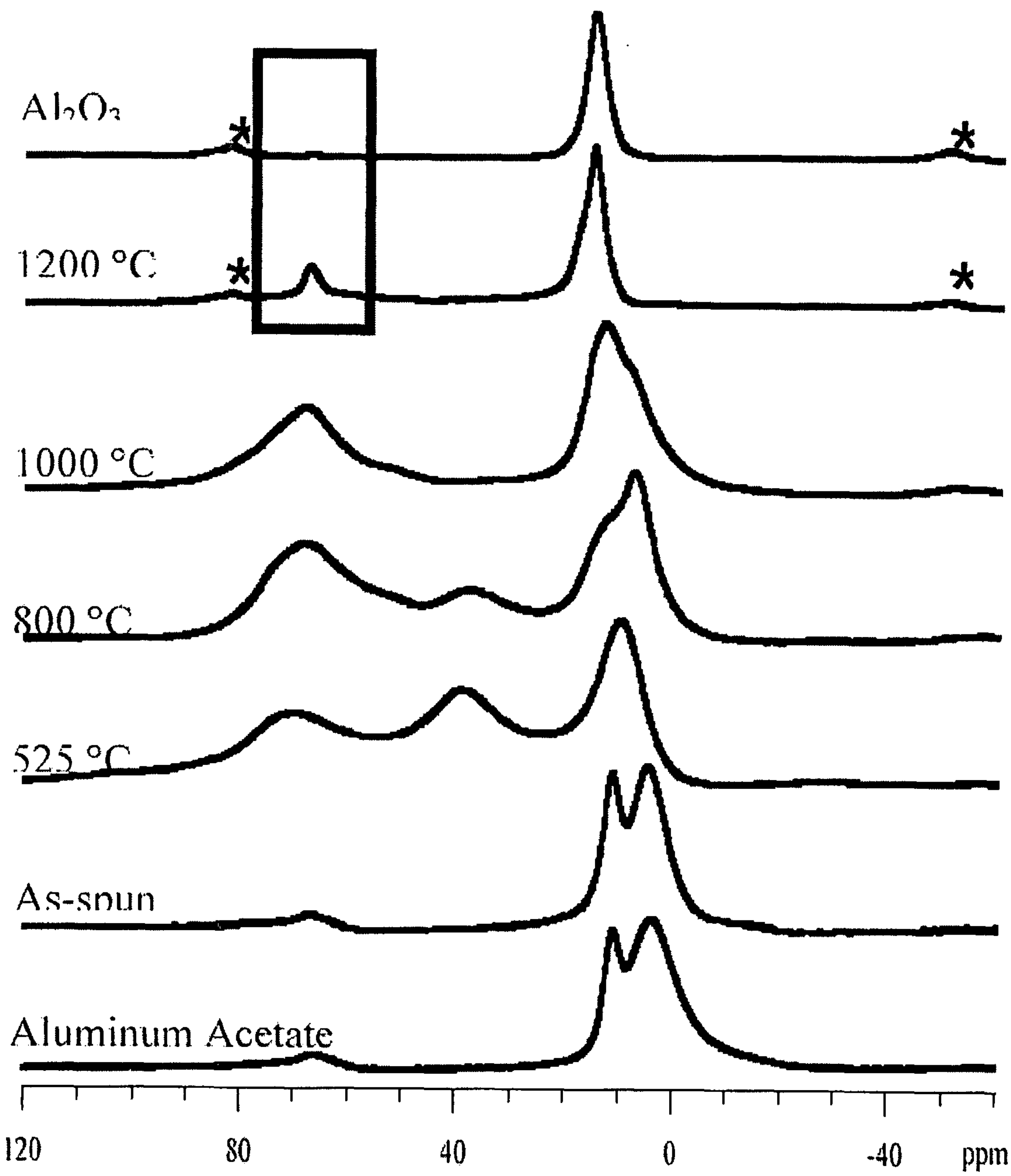
Al2O3
*
*
1200 °C
*
*
1000 °C
800 °C
525 °C
As-spun
Aluminum Acetate
120
80
40
0
-40
ppm

Figure 34

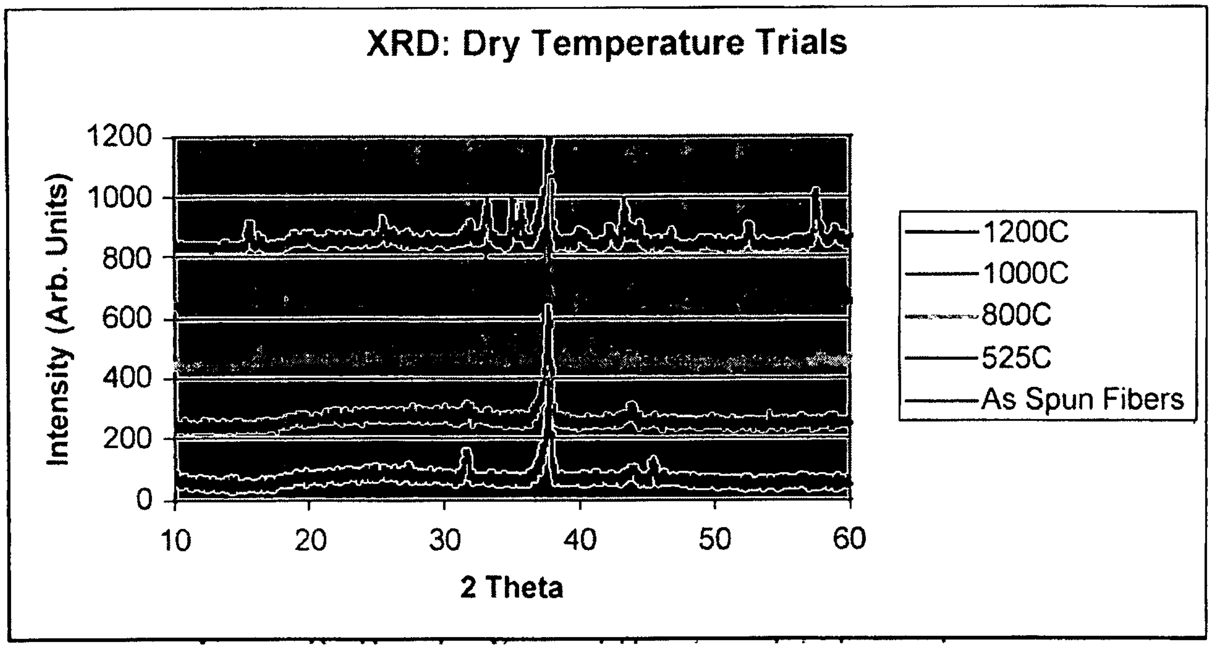


Figure 35

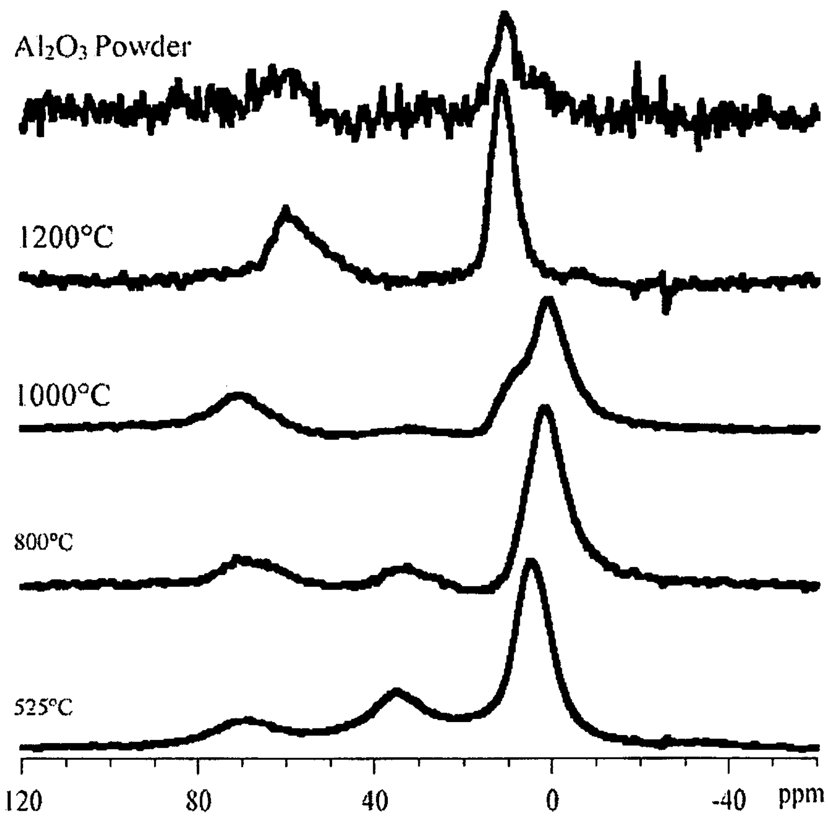


Figure 36

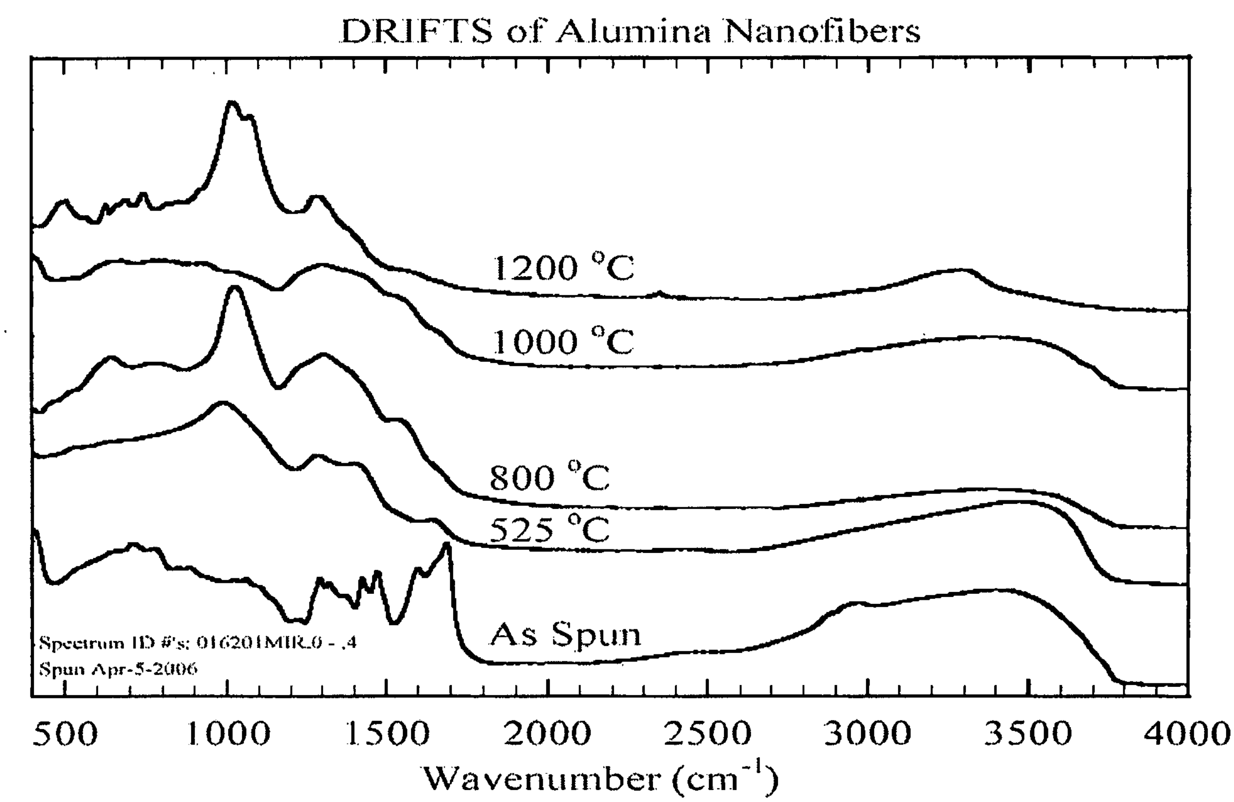
DRIFTS of Alumina Nanofibers
1200 °C
1000 °C
800 °C
525 °C
As Spun
Spectrum ID #'s: 016201MIR.0 - .4
Spun Apr-5-2006
500
1000
1500
2000
2500
3000
3500
4000
Wavenumber (cm-1)

Figure 37

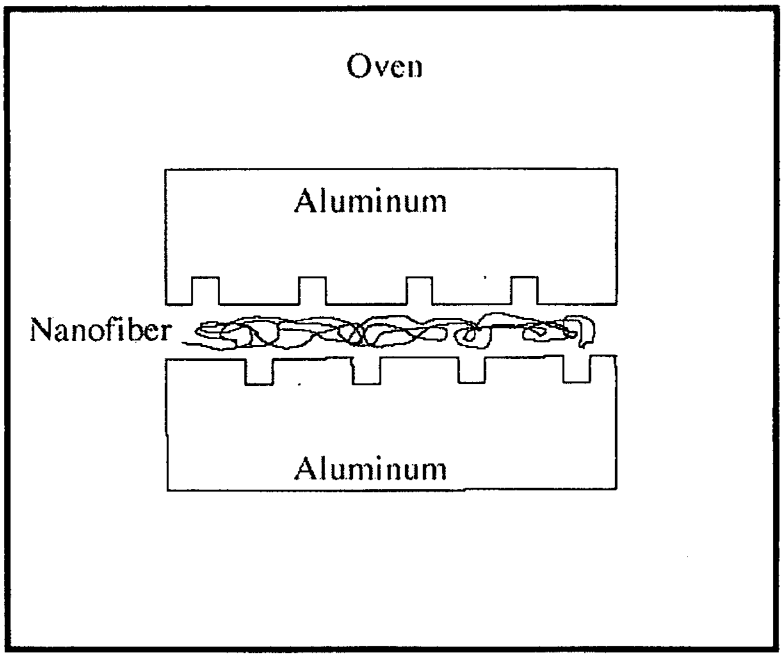


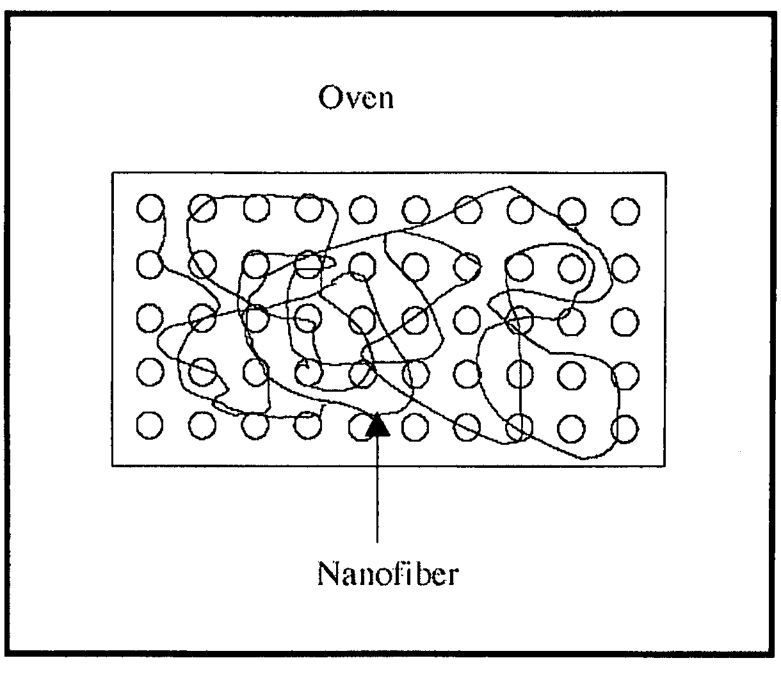


Figure 38

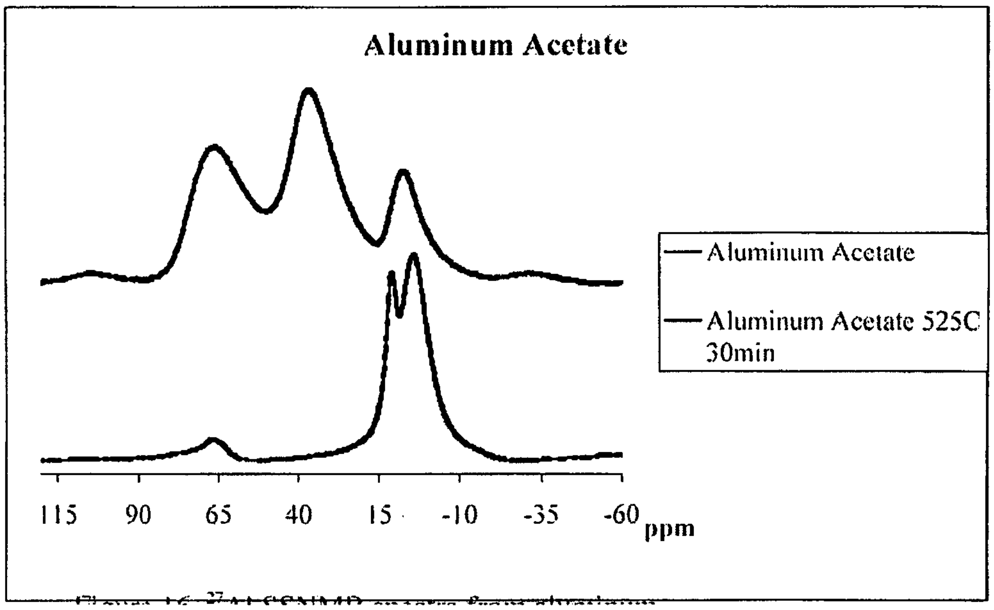


Figure 39

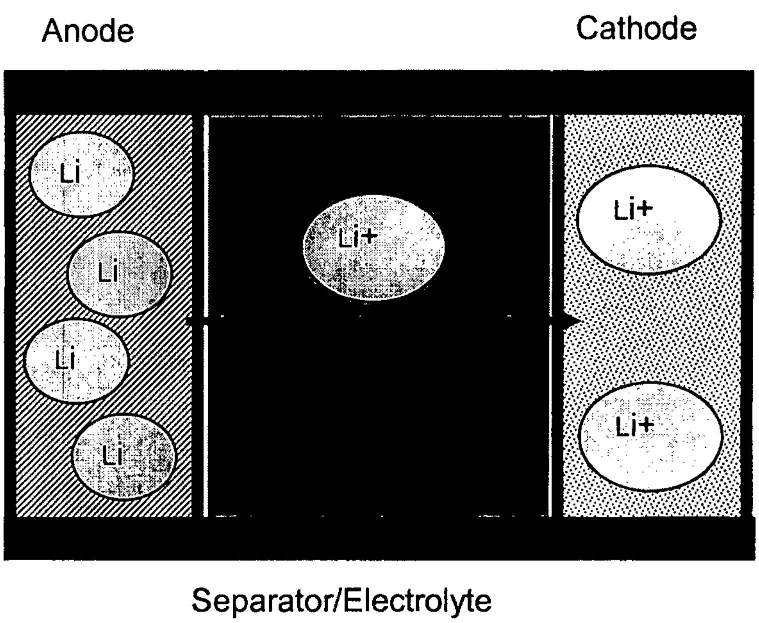


Figure 40

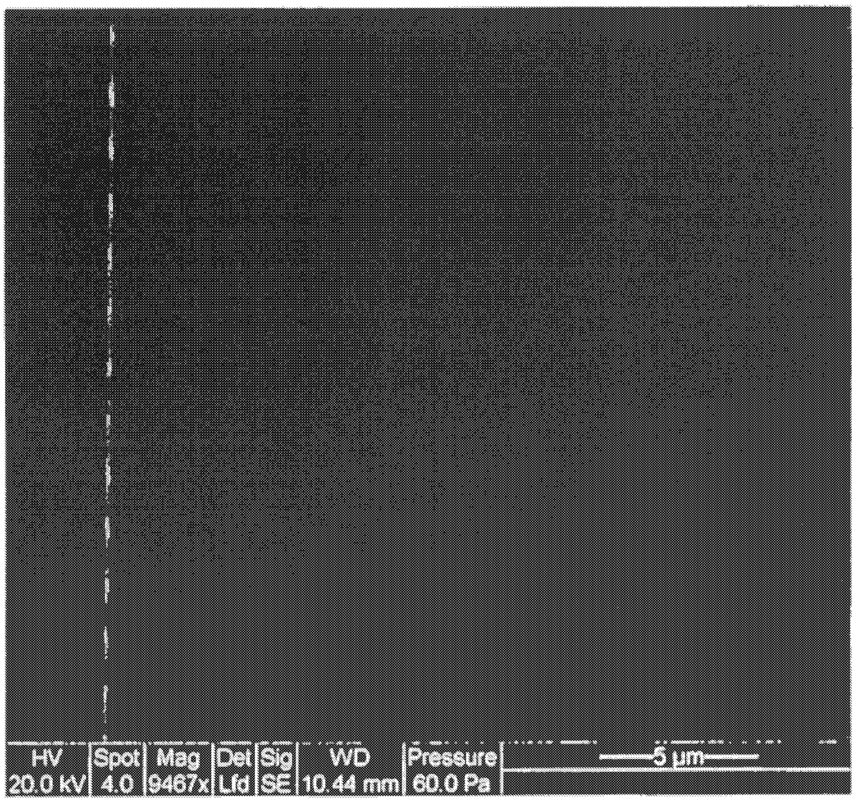
HV
20.0 kV
Spot
4.0
Mag
9467x
Det
Lfd
Sig
SE
WD
10.44 mm
Pressure
60.0 Pa
5 µm

Figure 41

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 84818906 P
- US 91945307 P
- US 93949807 P
- US 6753454 B